# EUROPÄISCHE PATENTANMELDUNG

(11) **EP 4 403 931 A1**
(43) Veröffentlichungstag der Anmeldung: **24.07.2024**
(21) Anmeldenummer: 24150541.1
(22) Anmeldetag: 05.01.2024
(51) Int. Cl.: G01R 19/25, G01R 31/08

(54) **VERFAHREN UND VORRICHTUNG ZUR KABELFEHLERFRÜHERKENNUNG**

(30) Priorität: 20.01.2023 DE 102023101473
(71) Anmelder: Westnetz GmbH, 44139 Dortmund (DE)
(72) Erfinder: Deutsch, Johannes, 54295 Trier (DE); Lombard, Ralf, 54516 Wittlich (DE)
(74) Vertreter: Bals & Vogel Patentanwälte PartGmbB

(57) **Zusammenfassung**

Die Erfindung betrifft ein Verfahren (100) zur Überwachung wenigstens einer Energieleitung (5) in einem Niederspannungsnetz (4), wobei an der Energieleitung (5) zumindest temporär eine, vorzugsweise sinusförmige, elektrische Wechselspannung mit einer ersten Frequenz anliegt.

## Beschreibung

Die Erfindung betrifft ein Verfahren mit den Merkmalen des unabhängigen Patentanspruchs 1, eine Vorrichtung mit den Merkmalen des unabhängigen Patentanspruchs 11, eine Transformatorenstation mit den Merkmalen des unabhängigen Patentanspruchs 13, ein System mit den Merkmalen des unabhängigen Patentanspruchs 14, ein Computerprogrammprodukt mit den Merkmalen des unabhängigen Patentanspruchs 15 sowie ein computerlesbares Speichermedium mit den Merkmalen des unabhängigen Patentanspruchs 16.

Die Verteilung des elektrischen Stroms zur Energieversorgung von Haushalten und Industriebetrieben erfolgt auf Grundlage mehrerer Stromnetz- bzw. Spannungsebenen. Eine überregionale Verteilung des Stroms erfolgt über Hochspannungsnetze. Eine daran anschließende regionale Unterverteilung wird hingegen über Mittelspannungsnetze realisiert. Die Belieferung der Endkunden erfolgt schließlich über lokale Verteilnetze, welche mit Niederspannung betrieben werden. Den einzelnen Netz- bzw. Spannungsebenen sind Transformationsanlagen (bspw. Umspannwerke oder Transformatorenstationen) zwischengeschaltet, welche bspw. eine Transformation von Hochspannung auf Mittelspannung oder von Mittelspannung auf Niederspannung ermöglichen.

Da das Niederspannungsnetz unmittelbar zur Belieferung der Endkunden dient, führen Fehler und Störungen in Energieleitungen von Niederspannungsnetzen häufig zu einer unmittelbaren und spürbaren Beeinträchtigung von Endkunden. Eine solche Beeinträchtigung kann bspw. der zumindest temporäre Wegfall der Energieversorgung einzelner Haushalte und/oder Betriebe sein, da im Falle einer gestörten Leitung eine Energieversorgung der betreffenden Endkunden nicht oder zumindest nicht unmittelbar über andere Zweige des Energieversorgungsnetzes kompensiert werden kann. Entsprechend sind auch Fehler und Störungen, welche lediglich eine kurze Unterbrechung der Energieversorgung auf einzelnen Energieleitungen des Niederspannungsnetzes bewirken, oft unmittelbar von den durch die betreffende Energieleitung belieferten Endkunden wahrnehmbar.

Der Wegfall der Energieversorgung einzelner Haushalte und/oder Betriebe wirkt sich unmittelbar auf die Zufriedenheit der Endkunden aus und kann je nach Dauer immense Folgeschäden verursachen. So kann es im Falle einer unterbrochenen Energieversorgung dazu kommen, dass die Produktions- bzw. Geschäftsaktivitäten in den betroffenen Betrieben lediglich eingeschränkt oder gar nicht aufrechterhalten werden können. Ferner können Sicherheitssysteme in ihrer Funktion beeinträchtigt werden. Auch der Betrieb von Kühlgeräten bspw. zur Lagerung von Lebensmitteln kann im Falle einer fehlenden Energieversorgung nicht aufrechterhalten werden.

Es ist daher eine Aufgabe der vorliegenden Erfindung, wenigstens einen der voranstehend beschriebenen Nachteile zumindest teilweise zu überwinden. Insbesondere ist es Aufgabe der Erfindung einen möglichst stabilen und zuverlässigen Betrieb eines Niederspannungsnetzes auf möglichst einfache und/oder kostengünstige Weise sicherzustellen.

Die voranstehende Aufgabe wird gelöst durch ein Verfahren mit den Merkmalen des unabhängigen Patentanspruchs 1, durch eine Vorrichtung mit den Merkmalen des unabhängigen Patentanspruchs 11, durch eine Transformatorenstation mit den Merkmalen des unabhängigen Patentanspruchs 13, durch ein System mit den Merkmalen des unabhängigen Patentanspruchs 14, durch ein Computerprogrammprodukt mit den Merkmalen des unabhängigen Patentanspruchs 15 sowie durch ein computerlesbares Speichermedium mit den Merkmalen des unabhängigen Patentanspruchs 16. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Vorrichtung und/oder im Zusammenhang mit der erfindungsgemäßen Transformatorenstation und/oder im Zusammenhang mit dem erfindungsgemäßen System und/oder im Zusammenhang mit dem erfindungsgemäßen Computerprogrammprodukt und/oder im Zusammenhang mit dem erfindungsgemäßen computerlesbaren Speichermedium und jeweils umgekehrt, so dass bezüglich der Offenbarung zu den einzelnen Erfindungsaspekten stets wechselseitig Bezug genommen wird bzw. werden kann.

Erfindungsgemäß vorgesehen ist ein Verfahren zur Überwachung wenigstens einer Energieleitung in einem Niederspannungsnetz, wobei an der Energieleitung zumindest temporär eine, vorzugsweise sinusförmige, elektrische Wechselspannung mit einer ersten Frequenz anliegt, das Verfahren wenigstens umfassend:
- Erfassen von Stromstärkewerten durch eine zeitdiskrete Erfassung der elektrischen Stromstärke in der Energieleitung, insbesondere durch eine Erfassungseinheit, wobei die Erfassung der Stromstärkewerte mit einer zweiten Frequenz erfolgt, wobei die zweite Frequenz zur Erfassung der Stromstärkewerte höher ist als die erste Frequenz der Wechselspannung,
- Auswerten wenigstens eines Stromstärkewerts, insbesondere durch eine Auswerteeinheit, das Auswerten umfassend einen Vergleich wenigstens eines Stromstärkewerts mit einem Stromstärkegrenzwert,
- Aktivieren eines Alarmprotokolls, insbesondere durch eine Steuereinheit, sofern der Stromstärkegrenzwert durch wenigstens einen der erfassten Stromstärkewerte überschritten wurde.

In anderen Worten wird durch die Erfindung ein Verfahren zur Überwachung wenigstens einer Energieleitung eines Niederspannungsnetzes bereitgestellt. An der Energieleitung liegt eine elektrische Wechselspannung mit einer ersten Frequenz an. Erfindungsgemäß ist vorgesehen, dass eine zeitlich diskrete Erfassung der elektrischen Stromstärke in der Energieleitung, insbesondere auf wenigstens einem Innenleiter der Energieleitung, erfolgt. Die hierdurch erfassten Stromstärkewerte werden mit einer zweiten Frequenz erfasst. Dabei ist die zweite Frequenz zur Erfassung der Stromstärkewerte höher als die erste Frequenz der Wechselspannung. In anderen Worten ist vorgesehen, dass innerhalb einer Periode bzw. Periodendauer der Wechselspannung mehrere Stromstärkewerte erfasst werden. Ferner ist vorgesehen, dass die erfassten Stromstärkewerte ausgewertet werden, wobei das Auswerten einen Vergleich wenigstens eines Stromstärkewerts, insbesondere aller Stromstärkewerte, mit einem Stromstärkegrenzwert umfasst. Die Überschreitung des Stromstärkegrenzwerts durch wenigstens einen Stromstärkewert kennzeichnet dabei ein Fehlereignis in der Energieleitung, sodass in einem solchen Falle ein Alarmprotokoll aktiviert wird um weitere Aktionen bzw. Sicherheitsmaßnahmen (sofern erforderlich) in die Wege zu leiten.

Im Rahmen der vorliegenden Erfindung wurde festgestellt, dass sich gravierende Fehler in Energieleitungen eines Niederspannungsnetzes (Kabelfehler), welche bspw. zu Versorgungsausfällen bei Endkunden führen, zumindest in machen Fehlerfällen durch zeitlich vorhergehende und weniger gravierende Fehlerereignisse ankündigen. Diese weniger gravierenden Fehlerereignisse können durch den Endkunden spürbar sein, führen i. d. R. jedoch nicht zu einer längeren bzw. spürbaren Unterbrechung der Energieversorgung. So kann ein solches weniger gravierendes Fehlerereignis bspw. ein Lichtflackern beim Endkunden auslösen, den kontinuierlichen Betrieb elektrischer Geräte aber im Wesentlichen nicht beeinträchtigen.

Es wurde festgestellt, dass sich die weniger gravierenden Fehlerereignisse in einer zeitlich begrenzten Änderung der Stromstärke bzw. der elektrischen Spannung in der Energieleitung ausprägen. So kann es bspw. zu zeitlich begrenzten Fehler- bzw. Kurzschlussströmen in der Größenordnung von 1500 A bis 8000 A kommen, die über einen Zeitraum von wenigen Milli- oder sogar Mikrosekunden auftreten. Aufgrund der äußerst geringen Zeitspanne dieses Ereignisses erfolgt keine Auslösung einer der Energieleitung zugeordneten Sicherung, was eine Unterbrechung der Energieversorgung beim Kunden bedeuten würde. Oft zeigt sich ein solcher Fehlerstrom einer Halbschwingung der elektrischen Wechselspannung. Die Rückkehr zum Normalwert erfolgt meist schon bei Erreichen des nächsten Nulldurchgangs des Spannungssignals. In anderen Worten wurde festgestellt, dass der (weniger gravierende) Fehler (bspw. ein ungewollter Lichtbogen) häufig in einer Halbschwingung der Wechselspannung durchzündet und beim nächsten Nulldurchgang der anliegenden Wechselspannung erlischt.

Diese Erkenntnis wurde im Rahmen der vorliegenden Erfindung gewinnbringend genutzt. Durch das erfindungsgemäße Verfahren werden die Stromstärkewerte in einer zweiten Frequenz erfasst, wobei die zweite Frequenz höher ist als die Frequenz der an der Energieleitung anliegenden Wechselspannung. Hierdurch wird sichergestellt, dass auch kurzzeitig (bspw. in einer Halbschwingung der Wechselspannung) auftretende Fehlerereignisse messtechnisch erfasst und ausgewertet werden können. Entsprechend ergibt sich der Vorteil, dass bereits weniger gravierende Fehler in einer Energieleitung zuverlässig detektiert und entsprechende Sicherheits- bzw. Wartungsmaßnahmen in die Wege geleitet werden können. Hierdurch kann größeren Schäden an der betreffenden Energieleitung sowie einer Unterbrechung der Energieversorgung beim Endkunden zuverlässig vorgebeugt werden. Entsprechend kann durch das erfindungsgemäße Verfahren der zuverlässige und stabile Betrieb eines Niederspannungsnetzes auf einfache Weise sichergestellt werden.

Eine Energieleitung soll vorliegend als eine Leitung verstanden werden, über welche elektrische Energie bzw. Strom, insbesondere zu einem Endverbraucher, geleitet wird. Beispielsweise kann es sich hierbei um eine Energieleitung handeln, welche eine Versorgungsstrecke zwischen einem Verteilerknoten (bspw. einer Transformatorenstation) und einem Endverbraucher wie bspw. einem Haushalt oder einem Betrieb zumindest abschnittsweise überbrückt bzw. ausbildet.

Ein Niederspannungsnetz soll vorliegend als ein Stromnetz verstanden werden, über welches elektrische Energie bzw. Strom verteilt wird, wobei das Niederspannungsnetz mit einer elektrischen Spannung, insbesondere Wechselspannung von 1000 V oder weniger, insbesondere zumindest teilweise mit einer elektrischen Spannung von 230 V und/oder 400 V, betrieben wird. Hiermit ist gemeint, dass an wenigstens einer Energieleitung, insbesondere allen Energieleitungen, des Niederspannungsnetzes im Normalbetrieb eine Spannung von 1000 V oder weniger, insbesondere eine elektrische Spannung von 230 V und/oder 400 V, anliegt. Mittelspannungs- und Hochspannungsnetze weisen im Vergleich hierzu höhere elektrische Spannungen auf. Insbesondere kann es vorgesehen sein, dass über das Niederspannungsnetz eine Belieferung wenigstens eines Endkunden (bspw. eines Haushalts oder eines Betriebs) mit elektrischer Energie bzw. Strom erfolgt. Dabei umfasst das Niederspannungsnetz wenigstens eine Energieleitung, insbesondere mehrere bzw. eine Vielzahl von Energieleitungen.

Das Niederspannungsnetz kann Teil eines übergeordneten Stromnetzes mit weiteren Spannungsebenen (Mittelspannung, Hochspannung) sein, wobei das übergeordnete Stromnetz mehrere Niederspannungsnetze umfassen kann, welche bspw. zur elektrischen Versorgung räumlich getrennter Bereiche dienen. Hierunter kann bspw. die elektrische Versorgung verschiedener Ortschaften oder Städte bzw. Stadtteile durch unterschiedliche Niederspannungsnetze verstanden werden. Den unterschiedlichen Spannungsebenen des Stromnetzes (Hochspannung, Mittelspannung, Niederspannung) kann jeweils wenigstens eine Transformatorenstation und/oder wenigstens ein Umspannwerk zwischengeschaltet sein. Eine Transformatorenstation kann bspw. zur Transformation von Hoch- auf Mittelspannung oder von Mittel- auf Niederspannung dienen.

Eine elektrische Wechselspannung ist eine elektrische Spannung, deren Polarität sich regelmäßig umkehrt und deren zeitlicher Mittelwert null ist. Dabei kann der zeitliche Verlauf der Wechselspannung einem Sinusverlauf entsprechen, wobei in diesem Falle eine sinusförmige Wechselspannung vorliegt. Der zeitliche Verlauf der Wechselspannung ist periodisch und weist somit eine Periodendauer auf. Die Frequenz der Wechselspannung ergibt sich als Kehrwert der Periodendauer der Wechselspannung. Insbesondere kann es vorgesehen sein, dass die Periodendauer der Wechselspannung 0,02 s (Sekunden) bzw. die Frequenz der Wechselspannung 50 Hz beträgt.

Die Frequenz einer Erfassung soll vorliegend als eine Abtastrate eines (bspw. durch eine Erfassungseinheit empfangenen) Messignals verstanden werden. Eine Erfassungsfrequenz bzw. Abtastrate von 800 Hz entspräche folglich einer Erfassung von 800 Messwerten (bspw. Stromstärke- und/oder Spannungswerten) pro Sekunde.

Eine Halbschwingung soll vorliegend als derjenige Anteil einer, insbesondere sinusförmigen, Schwingung verstanden werden, in dem kein Vorzeichenwechsel stattfindet. Entsprechend ist jede Halbschwingung begrenzt durch zwei Nulldurchgänge des betreffenden Signals, bspw. einer Wechselspannung.

Es kann im Rahmen der Erfindung vorgesehen sein, dass einzelne Schritte eines erfindungsgemäßen Verfahrens zumindest teilweise parallel bzw. simultan ausgeführt werden. So kann es bspw. vorgesehen sein, dass das Erfassen von Stromstärkewerten und/oder Spannungswerten, insbesondere kontinuierlich, über einen längeren bzw. unbestimmten Zeitraum erfolgt und die erfasste Stromstärke- und/oder Spannungswerte parallel zur weitergehenden Erfassung, insbesondere kontinuierlich, ausgewertet werden. Auch kann es vorgesehen sein, dass das Erfassen von Stromstärke- und/oder Spannungswerten bzw. das Auswerten der erfassten Werte nicht durch das Aktivieren eines Alarmprotokolls unterbrochen wird, sondern unabhängig von einzelnen Auswerteergebnissen bzw. der Aktivierung eines Alarmprotokolls weitergeführt wird.

Es kann im Rahmen der Erfindung ferner von Vorteil sein, wenn die Auswertung von Stromstärke- und/oder Spannungswerten mit der gleichen Frequenz erfolgt wie die Erfassung der Stromstärke- und/oder Spannungswerte. Hierdurch wird der Vorteil erzielt, dass es keinen Datenstau von erfassten Messwerten gibt, deren Auswertung noch aussteht. Vielmehr kann ein synchroner Ablauf zwischen dem Erfassen und Auswerten von Stromstärke- und/oder Spannungswerten realisiert werden. Zusätzlich oder alternativ ist es im Rahmen der Erfindung denkbar, dass die Stromstärkewerte und/oder die Spannungswerte in äquidistanten Zeitabständen erfasst werden.

Im Rahmen der Erfindung kann es von Vorteil sein, dass in jeder Halbschwingung der Wechselspannung wenigstens 10 oder wenigstens 100 Stromstärkewerte und/oder Spannungswerte, insbesondere wenigstens 1000 Stromstärkewerte und/oder Spannungswerte, vorzugsweise wenigstens 10000 oder wenigstens 100000 Stromstärkewerte und/oder Spannungswerte, erfasst werden. Durch eine höhere Erfassungsfrequenz bzw. Abtastrate ergibt sich eine bessere Auflösung der Stromstärke bzw. Spannungsverlaufs. Somit ergibt sich der Vorteil, dass auftretende Fehlereignisse nicht unerkannt bleiben, sondern messtechnisch erfasst und ausgewertet werden.

Im Rahmen der Erfindung ist es denkbar, dass die zweite Frequenz zur Erfassung der Stromstärkewerte wenigstens 800 Hz, insbesondere wenigstens 1 kHz, vorzugsweise wenigstes 1 MHz, besonders bevorzugt wenigstens 2 MHz oder wenigstens 5 MHz beträgt. Durch eine höhere Erfassungsfrequenz bzw. Abtastrate ergibt sich eine bessere Auflösung der Stromstärke bzw. des Spannungsverlaufs. Somit ergibt sich der Vorteil, dass auftretende Fehlereignisse nicht unerkannt bleiben, sondern messtechnisch erfasst und ausgewertet werden.

Es kann im Rahmen der Erfindung ferner vorgesehen sein, dass in jedem Steigungsbereich der Halbschwingung wenigstens ein Stromstärkewert und/oder wenigstens ein Spannungswert, erfasst wird. In Bezug auf eine Halbschwingung wird zwischen zwei Steigungsbereichen unterschieden, wobei die Steigung zwischen einem Maximalbetrag und Null variiert und das Vorzeichen der Steigung (insbesondere bei allen Werten außer Null) in dem ersten Steigungsbereich gegensätzlich zu dem Vorzeichen in dem zweiten Spannungsbereich ist. Hierdurch ergibt sich der Vorteil, dass die Halbschwingung messtechnisch gut aufgelöst wird und innerhalb der Halbschwingung auftretende Fehlerereignisse zuverlässig erfasst werden können. Es kann vorgesehen sein, dass in jedem Steigungsbereich wenigstens zwei, insbesondere wenigstens 50, vorzugsweise wenigstens 500 oder wenigstens 5000 oder wenigstens 50000 Stromstärkewerte und/oder Spannungswerte erfasst werden.

Es kann im Rahmen der Erfindung vorgesehen sein, dass der Stromstärkegrenzwert ein Vielfaches, insbesondere das Dreifache bis Vierfache, des Nennstroms einer der Energieleitung zugeordneten Sicherung beträgt, wobei vorzugsweise der Nennstrom der der Energieleitung zugeordneten Sicherung 160 A, 200 A oder 250 A beträgt. In anderen Worten kann es vorgesehen sein, dass die Energieleitung mit einer elektronischen Sicherung gesichert ist, wobei die Sicherung dazu ausgebildet ist, die Energieversorgung der Energieleitung im Falle eines definierten Überstroms zu unterbrechen, damit eine Beschädigung der Energieleitung vermieden wird. Diejenige Stromstärke, ab dem die Sicherung auslöst, also die Energieversorgung der Energieleitung unterbricht, soll vorliegend als Nennstrom verstanden werden. Der Stromstärkegrenzwert kann ein Vielfaches, insbesondere das Dreifache bis Vierfache, des Nennstroms einer der Energieleitung zugeordneten Sicherung betragen. Hierdurch wird der Vorteil erzielt, dass Fehlerereignisse in der Energieleitung erst ab einem gewissen Schweregrad detektiert und entsprechende Sicherheits- bzw. Wartungsmaßnahmen auf den Weg gebracht werden. Auch kann eine fehlerhafte Aktivierung eines Alarmprotokolls aufgrund eines Grundrauschens bzw. eines Signalrauschens bei der Erfassung der Stromstärke- und/oder Spannungswerte hierdurch effektiv vermieden werden.

Es ist ferner denkbar, dass durch das Verfahren zusätzlich umfasst ist:
- Erfassen von Spannungswerten durch eine zeitdiskrete Erfassung der elektrischen Spannung in der Energieleitung, insbesondere durch eine Erfassungseinheit, wobei vorzugsweise die Erfassung der Spannungswerte mit der gleichen Frequenz erfolgt, wie die Erfassung der Stromstärkewerte und/oder die Erfassung eines Spannungswerts jeweils gleichzeitig mit der mit der Erfassung eines Stromstärkewerts erfolgt,
- Auswerten wenigstens eines Spannungswerts, insbesondere durch eine Auswerteeinheit.

In anderen Worten kann es vorgesehen sein, dass nicht nur die Stromstärke in der betreffenden Energieleitung überwacht wird, sondern ebenfalls die elektrische Spannung bzw. Wechselspannung messtechnisch erfasst wird. Dabei kann es vorgesehen sein, dass die Erfassung der Spannungswerten mit der gleichen Erfassungs- bzw. Abtastfrequenz erfolgt wie das Erfassen der Stromstärkewerte und/oder dass bei jeder Erfassung eines Stromstärkewerts auch ein Spannungswert erfasst wird. Dies hat den Vorteil, dass im Falle eines detektierten Stromstärkewerts, welcher den Stromstärkegrenzwert überschreitet, eine fundiertere Auswertung vorgenommen werden kann, ob ein Fehlerereignis vorliegt bzw. ein Alarmprotokoll aktiviert werden muss bzw. ein bereits aktiviertes Alarmprotokoll möglicherweise wieder deaktiviert werden kann.

Auch ist es denkbar, dass zusätzlich wenigstens eines der folgenden umfasst ist:
- Erstellen wenigstens eines Erfassungsdatensatzes, insbesondere durch eine Speichereinheit oder eine Auswerteeinheit, der Erfassungsdatensatz umfassend wenigstens einen Stromstärkewert sowie wenigstens einen Zeitstempel, wobei jedem Stromstärkewert in dem Erfassungsdatensatz wenigstens ein, insbesondere genau ein, Zeitstempel zugeordnet ist,
- Speichern wenigstens eines Erfassungsdatensatzes, insbesondere durch eine Speichereinheit und/oder auf einem Datenspeicher, wobei insbesondere jedem Erfassungsdatensatz ein übergeordneter Zeitstempel zugeordnet ist,
- Berechnen, insbesondere durch eine Auswerteeinheit oder eine Speichereinheit, einer Zeitdifferenz zwischen wenigstens einem in einem Erfassungsdatensatz enthaltenen Zeitstempel und einem Referenzzeitstempel und Löschen des dem Zeitstempel zugeordneten Stromstärkewertes und/oder Spannungswertes, sofern die Zeitdifferenz einen Zeitgrenzwert überschreitet
   und/oder
Berechnen, insbesondere durch eine Auswerteeinheit oder eine Speichereinheit, einer Zeitdifferenz zwischen wenigstens einem übergeordneten Zeitstempel eines Erfassungsdatensatzes und einem Referenzzeitstempel und Löschen des dem übergeordneten Zeitstempel zugeordneten Erfassungsdatensatzes, sofern die Zeitdifferenz einen Zeitgrenzwert überschreitet.

In anderen Worten kann es vorgesehen sein, dass im Rahmen eines erfindungsgemäßen Verfahrens ein Erstellen wenigstens eines Erfassungsdatensatzes erfolgt. Die Erstellung kann bspw. in einer Speichereinheit und/oder Auswerteeinheit und/oder Steuereinheit erfolgen. Wenigstens ein Erfassungsdatensatz umfasst wenigstens einen Stromstärkewert sowie wenigstens einen Zeitstempel, wobei insbesondere jedem Stromstärkewert wenigstens ein, insbesondere genau ein, Zeitstempel zugeordnet ist. Dabei kann ein einem Stromstärkewert zugeordneter Zeitstempel charakteristisch sein für den Zeitpunkt sein, an dem der Stromstärkewert erfasst wurde. Ferner kann es vorgesehen sein, dass wenigstens ein Erfassungsdatensatz wenigstens einen Spannungswert umfasst, wobei insbesondere jedem Spannungswert wenigstens ein, insbesondere genau ein, Zeitstempel zugeordnet ist. Dabei kann ein einem Spannungswert zugeordneter Zeitstempel charakteristisch sein für den Zeitpunkt, an dem der Spannungswert erfasst wurde. In diesem Zusammenhang ist es denkbar, dass wenigstens ein Erfassungsdatensatz wenigstens eine Wertegruppe umfasst, die Wertegruppe umfassend einen Stromstärkewert und einen Spannungswert, wobei jeder Wertegruppe wenigstens ein, insbesondere genau ein, Zeitstempel zugeordnet ist. Dabei kann ein einer Wertegruppe zugeordneter Zeitstempel charakteristisch sein für den Zeitpunkt, an dem die Wertegruppe bzw. der durch die Wertegruppe umfasste Stromstärke- und Spannungswert erfasst wurde. Die Bildung von Wertegruppen bietet sich insbesondere an, wenn Stromstärkewerte und Spannungswerte gleichzeitig erfasst werden, da hierdurch eine vereinfachte Zuordnung von Zeitstempeln erfolgen kann und das Speichern redundanter Daten vermieden werden kann.

Wenigstens ein Erfassungsdatensatz kann mehrere Stromstärkewerte und/oder Spannungswerte und/oder Zeitstempel umfassen. Insbesondere kann es vorgesehen sein, dass wenigstens ein Erfassungsdatensatz mehrere Stromstärkewerte und/oder Spannungswerte umfasst, welche über einen zusammenhängenden Erfassungszeitraum erfasst wurden. Hiermit ist gemeint, dass der Erfassungsdatensatz alle in dem Erfassungszeitraum, insbesondere für eine Energieleitung, erfassten Stromstärkewerte und/oder Spannungswerte und/oder Zeitstempel umfasst. Hierdurch ergibt sich der Vorteil, dass die erfassten Stromstärkewerte und/oder Spannungswerte in einer übersichtlichen und leicht zugänglichen Datenstruktur gebündelt werden, um den Zugang zu relevanten Daten nachfolgend möglichst einfach und effizient zu gestalten. Es kann vorgesehen sein, dass der Erfassungszeitraum den Zeitraum wenigstens einer Stunde, wenigstens eines Tages (24 Stunden) oder wenigstens eines Kalendermonats abbildet.

Ferner kann es vorgesehen sein, dass wenigstens ein Erfassungsdatensatz wenigstens einen, insbesondere genau einen, übergeordneten Zeitstempel umfasst. Der übergeordnete Zeitstempel kann für den durch den Erfassungsdatensatz abgebildeten Erfassungszeitraum charakteristisch sein. Es kann es vorgesehen sein, dass der übergeordnete Zeitstempel wenigstens einen Anfangszeitpunkt des Erfassungszeitraums und/oder wenigstens einen Endzeitpunkt des Erfassungszeitraums umfasst. Hierdurch ergibt sich der Vorteil, dass der Erfassungszeitraum eines Erfassungsdatensatzes einfach und effizient ausgelesen werden kann, ohne dass eine Auswertung der in dem Erfassungsdatensatz enthaltenen Stromstärke- und/oder Spannungswerte bzw. den jeweils zugeordneten Zeitstempeln erfolgen muss.

Ferner kann es vorgesehen sein, dass im Rahmen der vorliegenden Erfindung ein Speichern wenigstens eines Erfassungsdatensatzes, insbesondere aller Erfassungsdatensätze, erfolgt. Das Speichern kann durch eine Speichereinheit und/oder eine Auswerteeinheit und/oder eine Steuereinheit erfolgen. Ferner kann es vorgesehen sein, dass das Speichern auf wenigstens einem Datenspeicher erfolgt, wobei vorzugsweise wenigstens ein Datenspeicher durch eine Speichereinheit und/oder eine Auswerteeinheit und/oder eine Steuereinheit umfasst ist. Auch ist es denkbar, dass das Speichern wenigstens eines Erfassungsdatensatzes, insbesondere aller Erfassungsdatensätze, redundant erfolgt. Hiermit ist gemeint, dass das Speichern auf zwei unabhängigen Datenspeichern erfolgt. Hierdurch wird der Vorteil erzielt, dass die Erfassungsdatensätze nicht verloren gehen, selbst wenn einer der Datenspeicher funktionell beeinträchtigt ist. Durch die Verwendung weiterer Datenspeicher kann der Grad der Redundanz entsprechend erhöht werden. Wenigstens ein Datenspeicher kann vorzugsweise als ein nichtflüchtiger Datenspeicher, insbesondere als SSD (Solid-State-Drive) oder Flash-Speicher oder ein magnetisches Speichermedium wie ein HDD-Speicher (Hard-Disk-Drive) ausgebildet sein. Das Speichern der erfassten Stromstärke bzw. Spannungswerte bietet den Vorteil, dass die erfassten Daten zumindest temporär zugänglich gehalten werden. So können bspw. im Falle einer detektierten Fehlfunktion einer Energieleitung auch zeitlich zurückliegende Messdaten dieser Energieleitung zur Analyse der Fehlfunktion herangezogen werden bzw. sicherheitshalber überprüft werden, ob der Betrieb der Energieleitung in der Vergangenheit tatsächlich fehlerfrei war. Auch kann anhand einer solchen rückschauenden Auswertung der Erfassten Stromstärke- und/oder Spannungswerte eine ggf. erforderliche Anpassung des Stromstärkegrenzwerts einfacher abgeleitet werden.

Ferner kann es vorgesehen sein, dass, insbesondere in regelmäßigen Zeitabständen, die Berechnung wenigstens einer Zeitdifferenz zwischen wenigstens einem in einem Erfassungsdatensatz enthaltenen Zeitstempel und einem Referenzzeitstempel, insbesondere durch eine Auswerteeinheit und/oder eine Steuereinheit und/oder eine Speichereinheit, erfolgt. Die Berechnung kann wiederkehrend, insbesondere wenigstens stündlich und/oder wenigstens täglich, durchgeführt werden. Der Referenzzeitstempel kann charakteristisch für einen Referenzzeitpunkt sein, wobei insbesondere sich anhand des Referenzzeitstempels ein aktuelles Alter eines dem in dem Erfassungsdatensatz enthaltenen Zeitstempel zugeordneten Stromstärke- und/oder Spannungswerts ermitteln lässt. Es kann vorgesehen sein, dass der Referenzzeitpunkt wiederkehrend, insbesondere in regelmäßigen Zeitabständen, insbesondere mit jeder Initiierung eines Löschvorgangs, aktualisiert wird. Eine Aktualisierung kann bedeuten, dass der Referenzzeitstempel auf die bei der Aktualisierung aktuelle Zeit gesetzt wird. So kann eine Zeitdifferenz aus dem Referenzzeitstempel und dem in dem Erfassungsdatensatz enthaltenen Zeitstempel berechnet und das Alter der dem in dem Erfassungsdatensatz enthaltenen Zeitstempel zugeordneten Stromstärke- und/oder Spannungswert ermittelt werden. Es kann vorgesehen sein, dass dies für mehrere, insbesondere alle, in wenigstens einem Erfassungsdatensatz enthaltenen Zeitstempel bzw. Strom- und/oder Spannungswerte und/oder für mehrere, insbesondere alle, Erfassungsdatensätze, insbesondere regelmäßig, durchgeführt wird.

Es kann ferner vorgesehen sein, dass wenn die berechnete Zeitdifferenz einen Zeitgrenzwert überschreitet, ein Löschen des dem in dem Erfassungsdatensatz enthaltenen Zeitstempel zugeordneten Stromstärkewerts und/oder Spannungswerts, insbesondere durch eine Auswerteeinheit und/oder eine Steuereinheit und/oder eine Speichereinheit, erfolgt (Löschvorgang). Der Zeitgrenzwert kann wenigstens eine Minute und/oder wenigstens eine Stunde und/oder wenigstens 24 Stunden betragen. Hierdurch ergibt sich der Vorteil, dass Datensätze in denen keine Fehlfunktion der Energieleitung detektiert wurde bzw. voraussichtlich nicht mehr benötigt werden, regelmäßig gelöscht werden. Hierdurch kann die aufgrund einer hochfrequenten Erfassung der Stromstärke und/oder Spannung anfallende Datenmenge reduziert bzw. auf einem konstant niedrigen Niveau gehalten werden. Die Initiierung eines solchen Löschvorgangs kann wenigstens stündlich und/oder wenigstens täglich erfolgen.

Zusätzlich oder alternativ kann es vorgesehen sein, dass, insbesondere in regelmäßigen Zeitabständen, die Berechnung wenigstens einer Zeitdifferenz wenigstens einem übergeordneten Zeitstempel eines Erfassungsdatensatzes und einem Referenzzeitstempel, insbesondere durch eine Auswerteeinheit und/oder eine Steuereinheit und/oder eine Speichereinheit, erfolgt. Die Berechnung kann wiederkehrend, insbesondere wenigstens stündlich und/oder wenigstens täglich, durchgeführt werden. Der Referenzzeitstempel kann charakteristisch für einen Referenzzeitpunkt sein, wobei insbesondere sich anhand des Referenzzeitstempels ein aktuelles Alter eines Erfassungsdatensatzes ermitteln lässt. Es kann vorgesehen sein, dass der Referenzzeitpunkt wiederkehrend, insbesondere in regelmäßigen Zeitabständen, insbesondere mit jeder Initiierung eines Löschvorgangs. aktualisiert wird. Eine Aktualisierung kann bedeuten, dass der Referenzzeitstempel auf die bei der Aktualisierung aktuelle Zeit gesetzt wird. So kann eine Zeitdifferenz aus dem Referenzzeitstempel und dem übergeordneten Zeitstempel des Erfassungsdatensatzes berechnet und das Alter des Erfassungsdatensatzes ermittelt werden. Es kann vorgesehen sein, dass dies für mehrere, insbesondere alle, Erfassungsdatensätze, insbesondere regelmäßig, durchgeführt wird.

Es kann ferner vorgesehen sein, dass wenn die berechnete Zeitdifferenz einen Zeitgrenzwert überschreitet, ein Löschen des Erfassungsdatensatzes, insbesondere durch eine Auswerteeinheit und/oder eine Steuereinheit und/oder eine Speichereinheit, erfolgt (Löschvorgang). Der Zeitgrenzwert kann wenigstens eine Minute und/oder wenigstens eine Stunde und/oder wenigstens 24 Stunden betragen. Hierdurch ergibt sich der Vorteil, dass Datensätze, in denen keine Fehlfunktion der Energieleitung detektiert wurde bzw. voraussichtlich nicht mehr benötigt werden, regelmäßig gelöscht werden. Eine gebündelte Betrachtung von Erfassungsdatensätzen anstatt aller in einem Erfassungsdatensatz enthaltenen Stromstärke- und/oder Spannungswerte ermöglicht ferner eine effizientere Durchführung der Löschvorgänge. Hierdurch kann die aufgrund einer hochfrequenten Erfassung der Stromstärke und/oder Spannung anfallende Datenmenge reduziert bzw. auf einem konstant niedrigen Niveau gehalten werden. Die Initiierung eines solchen Löschvorgangs kann wenigstens stündlich und/oder wenigstens täglich erfolgen.

Ferner kann es im Rahmen der Erfindung vorgesehen sein, dass das Alarmprotokoll zusätzlich wenigstens eines der nachfolgenden umfasst:
- Erstellen und/oder Bereitstellen wenigstens eines Fehlerdatensatzes, insbesondere durch eine Steuereinheit, der Fehlerdatensatzes umfassend wenigstens einen Stromstärkewert sowie wenigstens einen Zeitstempel, wobei jedem Stromstärkewert in dem Fehlerdatensatz wenigstens ein, insbesondere genau ein, Zeitstempel zugeordnet ist,
- Übertragen wenigstens eines bzw. des Fehlerdatensatzes, insbesondere durch eine Kommunikationseinheit, an einen zentralen Server und/oder an wenigstens ein mobiles Gerät,
- Empfangen wenigstens einer Betriebsanweisung, insbesondere durch eine Kommunikationseinheit und/oder von einem zentralen Server bzw. einem mobilen Gerät,
- Durchführen einer Fehlerortung an der Energieleitung, insbesondere durch Impulsreflexion,
- Konfigurieren wenigstens einer Erfassungseinheit, insbesondere durch einen Benutzer, über ein mobiles Gerät und/oder über einen zentralen Server.

In anderen Worten kann es vorgesehen sein, dass bei einer Aktivierung des Alarmprotokolls das Erstellen bzw. Bereitstellen wenigstens eines Fehlerdatensatzes durchgeführt wird. Die Erstellung eines Fehlerdatensatzes kann vorzugsweise durch eine Steuereinheit und/oder eine Auswerteeinheit und/oder eine Speichereinheit erfolgen. Wenigstens ein Fehlerdatensatz umfasst wenigstens einen Stromstärkewert sowie wenigstens einen Zeitstempel, wobei insbesondere jedem Stromstärkewert wenigstens ein, insbesondere genau ein, Zeitstempel zugeordnet ist. Dabei kann ein einem Stromstärkewert zugeordneter Zeitstempel charakteristisch sein für den Zeitpunkt, an dem der Stromstärkewert erfasst wurde. Ferner kann es vorgesehen sein, dass wenigstens ein Fehlerdatensatz wenigstens einen Spannungswert umfasst, wobei insbesondere jedem Spannungswert wenigstens ein, insbesondere genau ein, Zeitstempel zugeordnet ist. Dabei kann ein einem Spannungswert zugeordneter Zeitstempel charakteristisch sein für den Zeitpunkt, an dem der Spannungswert erfasst wurde. In diesem Zusammenhang ist es denkbar, dass wenigstens ein Fehlerdatensatz wenigstens eine Wertegruppe umfasst, die Wertegruppe umfassend einen Stromstärkewert und einen Spannungswert, wobei jeder Wertegruppe wenigstens ein, insbesondere genau ein, Zeitstempel zugeordnet ist. Dabei kann ein einer Wertegruppe zugeordneter Zeitstempel charakteristisch sein für den Zeitpunkt, an dem die Wertegruppe bzw. der durch die Wertegruppe umfasste Stromstärke- und Spannungswert erfasst wurde. Die Bildung von Wertegruppen bietet sich insbesondere an, wenn Stromstärkewerte und Spannungswerte gleichzeitig erfasst werden, da hierdurch eine vereinfachte Zuordnung von Zeitstempeln erfolgen kann und das Speichern redundanter Daten vermieden werden kann.

Wenigstens ein Fehlerdatensatz kann mehrere Stromstärkewerte und/oder Spannungswerte und/oder Zeitstempel umfassen. Insbesondere kann es vorgesehen sein, dass wenigstens ein Fehlerdatensatz mehrere Stromstärkewerte und/oder Spannungswerte über einen zusammenhängenden Erfassungszeitraum umfasst. Hiermit ist gemeint, dass der Fehlerdatensatz alle in dem Erfassungszeitraum, insbesondere für eine Energieleitung, erfassten Stromstärkewerte und/oder Spannungswerte und/oder Zeitstempel umfasst. Hierdurch ergibt sich der Vorteil, dass die erfassten Stromstärkewerte und Spannungswerte in einer übersichtlichen und leicht zugänglichen Datenstruktur gebündelt werden, um den Zugang zu relevanten Daten nachfolgend möglichst einfach und effizient zu gestalten. Es kann vorgesehen sein, dass der Erfassungszeitraum den Zeitraum wenigstens einer Stunde, wenigstens eines Tages (24 Stunden) oder wenigstens eines Kalendermonats abbildet. Es kann ferner vorgesehen sein, dass wenigstens ein Fehlerdatensatz nach der Erstellung, insbesondere einer Kommunikationseinheit, bereitgestellt wird, vorzugsweise um wenigstens einen Fehlerdatensatz an wenigstens einen zentralen Server oder wenigstens ein mobiles Gerät zu übertragen.

Wenigstens ein Fehlerdatensatz kann eine Teilmenge wenigstens eines Erfassungsdatensatzes abbilden. Insbesondere kann es vorgesehen sein, dass der Erfassungszeitraum wenigstens eines Fehlerdatensatzes kleiner ist als der Erfassungszeitraum des Erfassungsdatensatzes bzw. aller Erfassungsdatensätze. Hierdurch wird der Vorteil erzielt, dass die zur Auswertung eines in einer Energieleitung detektierten Fehlers übermittelten Datenmengen reduziert werden können. Insbesondere kann der Erfassungszeitraum wenigstens eines Fehlerdatensatzes, insbesondere aller Fehlerdatensätze, weniger als 2 Sekunden, vorzugsweise weniger als 1 Sekunde, bevorzugt weniger als 0,1 Sekunden, besonders bevorzugt weniger als 0,02 Sekunden, betragen. Durch einen kurzen Erfassungszeitraum kann die im Falle einer Übertragung eines Fehlerdatensatzes zu übertagende Datenmenge entsprechend reduziert werden.

Im Rahmen der Erfindung ist es optional möglich, dass wenigstens ein Erfassungsdatensatz und/oder wenigstens ein Fehlerdatensatz zusätzlich wenigstens eine der nachfolgenden Informationen umfasst:
- Eine Lokalisierungsinformation,
- Eine Leitungsinformation.

Hierdurch ergibt sich der Vorteil, dass der Erfassungsdatensatz und/oder der Fehlerdatensatz nicht nur Informationen über den zeitlichen Stromstärke- und/oder Spannungsverlauf in einer Energieleitung umfasst, sondern ferner auch festgehalten wird, wo die Messinformationen erfasst wurden bzw. wo die betreffende Energieleitung zu finden ist und/oder um welche Energieleitung es sich genau handelt. Daher vereinfacht die Verwendung einer Lokalisierungsinformation und/oder Leitungsinformation eine anschließende Durchführung einer Fehlerortung und/oder von Reparaturmaßnahmen. In anderen Worten kann hierdurch realisiert werden, dass ein Erfassungsdatensatz und/oder ein Fehlerdatensatz für eine Energieleitung und/oder einen Erfassungsort spezifisch ist.

Alternativ oder zusätzlich kann es auch vorgesehen sein, dass jedem Stromstärkewert und/oder Spannungswert eines Erfassungsdatensatzes und/oder eines Fehlerdatensatzes eine Lokalisierungsinformation und/oder eine Leitungsinformation zugeordnet ist.

Eine Lokalisierungsinformation kann für den Ort, an dem die in dem Erfassungsdatensatz und/oder Fehlerdatensatz hinterlegten Stromstärke- und/oder Spannungswerte erfasst wurden, spezifisch sein. So kann eine Lokalisierungsinformation eine Standortinformation umfassen. Auch kann eine Lokalisierungsinformation einen Zeitstempel umfassen. Der Zeitstempel kann für den Zeitpunkt, an dem die Standortinformation erfasst wurde, spezifisch sein. Die Standortinformation kann als eine geografische Koordinateninformation ausgebildet sein. Eine Lokalisierungsinformation kann bspw. durch eine Lokalisierungseinheit erfasst werden. Wenigstens eine Lokalisierungseinheit kann einen Lokalisierungssensor umfassen, wobei der Lokalisierungssensor vorzugsweise zum Empfang eines Signals wenigstens eines globalen Navigationssatellitensystems, insbesondere NAVSTAR GPS, GLONASS, Galileo oder Beidou, ausgebildet ist. Somit kann die Lokalisierungsinformation bspw. einen Rückschluss darauf zulassen, in welcher Transformatorenstation der betreffende Erfassungsdatensatz und/oder Fehlerdatensatz erfasst bzw. erstellt wurde. Hierdurch ergibt sich der Vorteil, dass auf einfache Weise die örtliche Zuständigkeit ermittelt und geschultes Personal einfach und unkompliziert an den Ort des erkannten Fehlers ausgesendet werden kann.

Eine Leitungsinformation kann für eine Energieleitung spezifisch sein. Eine Leitungsinformation kann eine Leitungskennung umfassen. Die Leitungskennung kann als eine numerische, alphabetische oder alpha-numerische Zeichenfolge ausgebildet sein. In anderen Worten kann es vorgesehen sein, dass sich über die Leitungsinformation eine Energieleitung eindeutig identifizieren lässt. Aus Transformatorenstationen werden mitunter mehrere Energieleitungen zur Versorgung von Endkunden abgezweigt. Entsprechend ist es im Falle der Detektion einer Fehlfunktion einer Energieleitung nicht nur hilfreich zu wissen, wo der Fehler detektiert wurde, sondern darüber hinaus in welcher Leitung der Fehler detektiert wurde. Durch die Verwendung einer Leitungsinformation kann vor Ort somit einfach und eindeutig festgestellt werden, in welcher Leitung eine Fehlfunktion detektiert wurde und ggf. eine nachfolgende Fehlerortung durchgeführt werden muss. Es kann vorgesehen sein, dass die Leitungskennung vor Durchführung eines Verfahrens durch einen Benutzer definiert wird. Bspw. kann die Definition wenigstens einer Leitungskennung in einer Steuereinheit und/oder Auswerteeinheit erfolgen, sodass den durch die Erfassungseinheit erfassten Stromstärke- und/oder Spannungswerten bzw. Erfassungsdatensätzen eine Leitungskennung zugeordnet werden kann. Auch kann es vorgesehen sein, dass die Leitungskennung unmittelbar aus der Energieleitung ausgelesen wird. Dies kann bspw. durch die Auswerteeinheit erfolgen.

Ferner kann es im Rahmen der Erfindung vorgesehen sein, dass bei einer Aktivierung des Alarmprotokolls das Übertragen wenigstens eines Fehlerdatensatzes an einen zentralen Server und/oder an wenigstens ein mobiles Gerät, insbesondere durch eine Kommunikationseinheit, durchgeführt wird. Hierdurch wird es ermöglicht, dass die in Bezug auf einen in einer Energieleitung detektierten Fehler relevanten Daten für eine weitere Auswertung bzw. Analyse auf einem zentralen Server und/oder einem mobilen Gerät bereitgestellt werden. Die Auswertung eines Fehlerdatensatzes in wenigstens einem zentralen Server und/oder auf wenigstens einem mobilen Gerät kann zumindest teilweise automatisiert erfolgen und/oder zumindest teilweise manuell durch einen Benutzer erfolgen. Eine automatisierte Auswertung kann bspw. eine Filterung und/oder eine Glättung der in dem Fehlerdatensatz enthaltenen Daten umfassen. Es kann im Rahmen der Erfindung vorgesehen sein, dass die Übertragung wenigstens eines Fehlerdatensatzes zumindest teilweise drahtlos erfolgt. Zusätzlich oder alternativ kann es vorgesehen sein, dass die Übertragung wenigstens eines Fehlerdatensatzes zumindest teilweise drahtgebunden erfolgt. Im Rahmen einer drahtlosen Übertragung kann es vorgesehen sein, dass die Übertragung zumindest teilweise über Bluetooth, ein Wireless Local Area Network (WLAN), Troposphärenfunk (Troposcatter) und/oder Mobilfunk bzw. ein Mobilfunknetz erfolgt. Im Rahmen einer drahtgebundenen Übertragung kann es ferner vorgesehen sein, dass die Übertragung zumindest teilweise über ein Local Area Network (LAN) und/oder Power Line Communication erfolgt. Eine drahtlose Übertragung, insbesondere zumindest teilweise über ein Mobilfunknetz, bietet den Vorteil einer besonders einfachen Ausführung bei gleichzeitig schneller und weitgehend reichweitenunabhängiger Übertragung.

Ferner ist es im Rahmen der Erfindung denkbar, dass bei einer Aktivierung des Alarmprotokolls ein Empfangen wenigstens einer Betriebsanweisung erfolgt. Das Empfangen kann vorzugsweise durch eine Kommunikationseinheit erfolgen, wobei insbesondere die Betriebsanweisung von wenigstens einem zentralen Server und/oder wenigstens einem mobilen Gerät empfangen wird. Eine Betriebsanweisung kann wenigstens eine Anweisung zum Betrieb wenigstens einer Energieleitung umfassen. Ferner kann es vorgesehen sein, dass wenigstens eine Betriebsanweisung wenigstens eine Leitungsinformation umfasst, sodass eine Anweisung zum Betrieb einer Energieleitung der betreffenden Energieleitung zugeordnet werden kann. Es kann vorgesehen sein, dass wenigstens eine durch eine Kommunikationseinheit empfangene Betriebsanweisung einer Steuereinheit bereitgestellt wird, wobei die Steuereinheit zur Ausführung der Betriebsanweisung ausgebildet ist und/oder dazu ausgebildet ist, andere Einheiten, wie bspw. eine Erfassungseinheit zur Ausführung einzelner Schritte zur Umsetzung einer Betriebsanweisung, zu veranlassen.

Eine Betriebsanweisung kann bspw. wenigstens eine der folgenden Anweisungen umfassen:
- Anweisung zur Trennung der Energieversorgung wenigstens einer Energieleitung,
- Anweisung zum Durchführen einer Fehlerortung, insbesondere durch Impulsreflexion.

In anderen Worten kann es vorgesehen sein, dass die Betriebsanweisung eine Anweisung zur Trennung der Energieversorgung wenigstens einer Energieleitung umfasst. Dies kann insbesondere dann der Fall sein, wenn festgestellt wurde, dass eine in Bezug auf eine Energieleitung detektierte Fehlfunktion einen zumindest temporären sicheren Betrieb der Energieleitung gefährdet bzw. eine stärkere Beschädigung der Energieleitung kurz bevorsteht. Hierdurch kann es vorkommen, dass Endkunden zumindest temporär keine Energieversorgung erhalten. Meist kann die Ausfallzeit hierdurch dennoch insgesamt reduziert werden, da eine schlimmere Beschädigung der Energieleitung vermieden und der Aufwand zur Instandsetzung somit reduziert werden kann. Auch kann die Betriebsanweisung eine Anweisung zum Durchführen einer Fehlerortung umfassen. Hierdurch kann eine Lokalisierung des in der Energieleitung detektierten Fehlers erfolgen und nachfolgende Instandsetzungsarbeiten können effizient und zielgerichtet durchgeführt werden, ohne dass eine manuelle Fehlerortung durch entsprechendes Personal notwendig ist.

Ferner ist es denkbar, dass bei einer Aktivierung des Alarmprotokolls eine Fehlerortung an der Energieleitung durchgeführt wird. In anderen Worten kann es vorgesehen sein, dass die Fehlerortung automatisiert beim Auftreten eines Fehlers in der Energieleitung durchgeführt wird, ohne dass hierzu eine gesonderte Betriebsanweisung erforderlich ist.

Eine Fehlerortung kann durch Impulsreflexion erfolgen. Vorzugsweise werden im Rahmen der Fehlerortung elektrische Impulse in die betreffende Energieleitung eingebracht, welche an der Fehlerstelle in der Energieleitung zumindest teilweise reflektiert wird. Durch eine Laufzeitmessung des Impulses kann unter Verwendung der Ausbreitungsgeschwindigkeit des Impulses eine Lauflänge des Impulses in der Energieleitung bis zum Ort der Reflektion und somit eine Distanz des Fehlers in der Energieleitung vom Ort der Einbringung des Impulses in die Energieleitung ermittelt werden. Es kann im Rahmen der Erfindung vorgesehen sein, dass eine Erfassungseinheit und/oder eine Steuereinheit zur Durchführung einer Fehlerortung, insbesondere durch Impulsreflexion, ausgebildet ist.

Ferner ist es vorstellbar, dass wenigstens ein Fehlerdatensatz wenigstens zwei, vorzugsweise wenigstens drei, Stromstärkewerte in einem, insbesondere zusammenhängenden, Zeitintervall (Erfassungszeitraum) umfasst. Ferner kann es im Rahmen der Erfindung von Vorteil sein, dass ein Anfangszeitpunkt des Zeitintervalls bzw. des Erfassungszeitraums wenigstens eines Fehlerdatensatzes durch eines der folgenden Ereignisse festgelegt ist:
- Überschreiten des Stromstärkegrenzwerts durch wenigstens einen Stromstärkewert,
- Ein Anstieg der Stromstärke über wenigstens drei zeitlich aufeinanderfolgend erfasste Stromstärkewerte hinweg, wobei insbesondere die Steigung der Stromstärke zwischen je zwei Stromstärkewerten jeweils größer ist als ein vordefinierter Steigungsgrenzwert.

Es kann im Rahmen der Erfindung vorgesehen sein, dass der Steigungsgrenzwert als die Steigung der Stromstärke pro Zeiteinheit definiert ist. Es kann ferner vorgesehen sein, dass der Steigungsgrenzwert als eine Steigung von wenigstens 100 A/ms (Ampère pro Millisekunde), insbesondere als eine Steigung von wenigstens 200 A/ms, bevorzugt als eine Steigung von wenigstens 400 A/ms, besonders bevorzugt als eine Steigung von mehr als 500 A/ms definiert ist.

Im Rahmen der Erfindung ist es denkbar, dass ein Endzeitpunkt des Zeitintervalls bzw. Erfassungszeitraums wenigstens eines Fehlerdatensatzes durch wenigstens eines der folgenden Ereignisse festgelegt ist:
- Unterschreiten des Stromstärkegrenzwerts durch wenigstens einen Stromstärkewert,
- Ablauf einer Zeitspanne ab dem Anfangszeitpunkt des Zeitintervalls, wobei die Zeitspanne wenigstens ein Viertel, vorzugsweise wenigstens die Hälfte, der Periodendauer der an der Energieleitung anliegenden Wechselspannung beträgt.

Durch eine solche Definition des Anfangs- bzw. Endzeitpunkt des Erfassungszeitraums eines Fehlerdatensatzes ergibt sich der Vorteil, dass einem Fehlerdatensatz nur diejenigen Werte des Stromstärkeverlaufs zugeordnet werden, welche für eine weitergehende Auswertung bzw. Analyse des Fehlers relevant sind.

Ferner kann es vorgesehen sein, dass insbesondere vor der Erfassung von Stromstärke- und/oder Spannungswerten durch eine Erfassungseinheit, eine Konfiguration wenigstens einer Erfassungseinheit durchgeführt wird. Die Konfiguration kann eine Zuordnung einer Leitungskennung zu der Erfassungseinheit umfassen. Hierdurch wird gekennzeichnet, für welche Energieleitung die Erfassungseinheit eine Erfassung von Stromstärke und/oder Spannungswerten durchführt. Die Konfiguration kann manuell durch einen Benutzer erfolgen. Auch kann die Leitungskennung automatisiert, insbesondere durch die Erfassungseinheit, aus der Energieleitung ausgelesen werden. Auch kann die Konfiguration unter Verwendung wenigstens eines mobilen Geräts und/oder eines zentralen Servers erfolgen, wobei die Leitungskennung von dem mobilen Gerät und/oder dem zentralen Server an die Erfassungseinheit übermittelt wird. Hierzu kann es vorgesehen sein, dass die Leitungskennung zunächst an eine Kommunikationseinheit übermittelt wird und von der Kommunikationseinheit, insbesondere über eine Steuereinheit, weiter an die Erfassungseinheit übermittelt wird.

Es kann im Rahmen der Erfindung vorgesehen sein, dass das Alarmprotokoll zusätzlich umfasst:
- Auswerten wenigstens eines Spannungswertes in einem Auswertezeitraum vor dem Zeitstempel des ältesten Stromstärkewerts in einem Fehlerdatensatz durch den der Stromstärkegrenzwert überschritten wurde und Deaktivieren des Alarmprotokolls, sofern wenigstens ein Spannungswert in dem Auswertezeitraum, insbesondere wenigstens zwei aufeinanderfolgend erfasste Spannungswerte in dem Auswertezeitraum, den Wert null aufweist.

Der Auswertezeitraum kann ein Zeitraum von weniger als 0,1 Sekunden, vorzugsweise von wenigstens 0,05 Sekunden sein. Abseits der bereits beschriebenen Fehler in Energieleitungen können hohe Stromstärkewerte in einer Energieleitung auch bei der Herstellung einer Energieversorgung der Energieleitung kurzzeitig auftreten. Diese Ereignisse sind jedoch nicht gleichzusetzen mit einem Fehler in der Energieleitung und sollten entsprechend von der Detektion als möglicher Fehler ausgeschlossen werden. Dies kann erzielt werden, indem die elektrische Spannung vor dem Zeitpunkt ausgewertet wird, an dem das Überschreiten des Stromstärkegrenzwerts durch einen Stromstärkewert bezogen auf ein Fehlerereignis erstmalig festgestellt wurde. Dies entspricht folglich dem Stromstärkewert mit dem ältesten Zeitstempel in einem Fehlerdatensatz, durch den der Stromstärkegrenzwert überschritten wurde. Wenn festgestellt wird, dass vor der Erfassung dieses Stromstärkewerts keine Energieversorgung bzw. Spannungsversorgung der Energieleitung stattfand, so kann das Alarmprotokoll deaktiviert werden.

Es kann ferner vorgesehen sein, dass bei einer Aktivierung eines Alarmprotokolls ein Aktivierungsdatensatz, insbesondere durch die Steuereinheit, angelegt und/oder zumindest temporär, insbesondere durch eine Speichereinheit und/oder auf einem Datenträger, gespeichert wird. Der Aktivierungsdatensatz kann wenigstens einen Zeitstempel umfassen, wobei der Zeitstempel für den Aktivierungszeitpunkt des Alarmprotokolls spezifisch ist. Ferner kann der Aktivierungsstempel eine Leitungsinformation umfassen. Hierdurch kann festgestellt werden, in welcher Energieleitung ein Fehler detektiert wurde bzw. für welche Energieleitung ein Alarmprotokoll aktiviert wurde. Durch das Speichern wenigstens eines Aktivierungsdatensatzes kann die Fehlerhistorie in Bezug auf eine Energieleitung bzw. mehrere Energieleitungen konsistent nachvollzogen werden.

Ferner kann wenigstens ein Aktivierungsdatensatz eine Aktivierungsinformation umfassen, wobei durch die Aktivierungsinformation angegeben wird, ob das Alarmprotokoll noch aktiv ist. Hierdurch kann festgestellt werden, ob aktuell ein Alarmprotokoll für eine Energieleitung aktiviert wurde bzw. aktuell durchlaufen wird bzw. ob im Falle der Detektion eines Fehlerereignisses in einer Energieleitung ein neues Alarmprotokoll aktiviert werden soll oder nicht. Es kann vorgesehen sein, dass die Aktivierungsinformation bei Anlegen bzw. Erstellen eines Aktivierungsdatensatzes auf aktiv gesetzt wird, wobei aktiv meint, dass das Alarmprotokoll aktiviert wurde und aktuell keine erneute Aktivierung eines Alarmprotokolls erfolgen soll. Alternativ oder zusätzlich kann es vorgesehen sein, dass die Aktivierungsinformation nach Abschluss eines Alarmprotokolls und/oder bei Deaktivierung des Alarmprotokolls auf inaktiv gesetzt wurde, wobei inaktiv mein, dass im Falle eines in einer Energieleitung detektierten Fehlerereignisses ein neues Alarmprotokoll aktiviert wird. Hierdurch ergibt sich der Vorteil, dass wenn mehrere, insbesondere aufeinanderfolgend erfasste, Stromstärkewerte den Stromstärkegrenzwert übersteigen, nicht mehrere Alarmprotokolle aktiviert werden, sondern dieses Fehlerereignis in einem einzigen Alarmprotokoll bzw. Fehlerdatensatz gebündelt wird.

Es kann vorgesehen sein, dass die Aktivierungsinformation vor dem vollständigen Abschluss eines Alarmprotokolls bereits auf inaktiv gesetzt wird. So kann es bspw. vorgesehen sein, dass die Aktivierungsinformation mit dem Endzeitpunkt des Erfassungszeitraums des dem Alarmprotokolls zugeordneten Fehlerdatensatzes auf inaktiv gesetzt wird. Dies hat den Vorteil, dass keine Totzeiträume entstehen, in denen Stromstärke- bzw. Spannungswerte zwar erfasst aber mögliche Fehler in einer Energieleitung nicht detektiert bzw. gemeldet werden.

Die obenstehende Aufgabe wird ferner gelöst durch eine erfindungsgemäße Vorrichtung zur Überwachung wenigstens einer Energieleitung in einem Niederspannungsnetz, umfassend:
- Wenigstens eine Erfassungseinheit zur Erfassung von Stromstärkewerten durch eine zeitdiskrete Erfassung der elektrischen Stromstärke in wenigstens einer Energieleitung,
- Wenigstens eine Auswerteeinheit zur Auswertung wenigstens eines Stromstärkewerts und/oder wenigstens eines Spannungswerts,
- Wenigstens eine Steuereinheit zur Aktivierung eines Alarmprotokolls.

In Bezug auf eine erfindungsgemäße Vorrichtung ergeben sich die gleichen Vorteile, wie sie bereits in Bezug auf ein erfindungsgemäßes Verfahren beschrieben worden sind.

Es kann im Rahmen der Erfindung vorgesehen sein, dass durch eine Erfassungseinheit die Stromstärke und/oder elektrische Spannung in wenigstens einer, insbesondere genau einer, Energieleitung erfassbar ist. Entsprechend ist es denkbar, dass eine Vorrichtung wenigstens zwei bzw. mehrere Erfassungseinheiten umfasst, wobei jeweils eine Erfassungseinheit zur Erfassung der elektrischen Spannung und/oder der Stromstärke in jeweils einer Energieleitung ausgebildet ist.

Es kann vorgesehen sein, dass wenigstens eine Erfassungseinheit zur, insbesondere zeitlich diskreten, Erfassung der Stromstärke in wenigstens einer Energieleitung wenigstens einen Stromwandler umfasst. Der Stromwandler kann zumindest abschnittsweise ringförmig, insbesondere. als ein Durchsteckwandler oder Umbauwandler, ausgebildet sein, sodass eine Energieleitung zumindest abschnittsweise durch den Stromwandler hindurchführbar ist. Hierdurch ergibt sich der Vorteil, dass eine Erfassung der Stromstärke bei bereits existierenden Energieleitungen durchführbar ist. Die Messung der Stromstärke kann bevorzugt induktiv erfolgen.

Ferner kann wenigstens eine Erfassungseinheit zur Einbringung wenigstens eines Messimpulses in wenigstens eine Energieleitung ausgebildet sein. Vorzugsweise werden im Rahmen der Fehlerortung elektrische Impulse durch die Erfassungseinheit in die betreffende Energieleitung eingebracht, welche an der Fehlerstelle in der Energieleitung zumindest teilweise reflektiert wird. Durch eine Laufzeitmessung des Impulses kann unter Verwendung der Ausbreitungsgeschwindigkeit des Impulses eine Lauflänge des Impulses in der Energieleitung bis zum Ort der Reflektion und somit eine Distanz des Fehlers in der Energieleitung vom Ort der Einbringung des Impulses in die Energieleitung ermittelt werden. Hierdurch kann eine Ortung eines Fehlers in der Energieleitung durchgeführt werden.

Es kann vorgesehen sein, dass wenigstens eine Erfassungseinheit zur, insbesondere zeitlich diskreten, Erfassung der elektrischen Spannung in wenigstens einer Energieleitung wenigstens einen Spannungswandler umfasst. Der Spannungswandler kann zumindest abschnittsweise ringförmig, insbesondere als ein Durchsteckwandler oder Umbauwandler ausgebildet sein, sodass eine Energieleitung zumindest abschnittsweise durch den Spannungswandler hindurchführbar ist. Hierdurch ergibt sich der Vorteil, dass eine Erfassung der elektrischen Spannung bei bereits existierenden Energieleitungen durchführbar ist. Die Messung der Spannung kann bevorzugt induktiv und/oder kapazitiv erfolgen.

Wenigstens eine Erfassungseinheit und/oder wenigstens eine Auswerteeinheit und/oder wenigstens eine Speichereinheit und/oder wenigstens eine Steuereinheit kann derart ausgebildet sein, dass zumindest zeitweise eine Kommunikationsverbindung, insbesondere wenigstens zur Übertragung erfasster Stromstärke und/oder Spannungswerte, zwischen wenigstens einer Erfassungseinheit und wenigstens einer Auswerteeinheit und/oder wenigstens einer Speichereinheit und/oder wenigstens einer Steuereinheit herstellbar ist.

Es kann im Rahmen der Erfindung vorgesehen sein, dass wenigstens eine Auswerteeinheit zur Auswertung der Stromstärkewerte und/oder Spannungswerte mehrerer Erfassungseinheiten ausgebildet ist. So ist es bspw. denkbar, dass die Erfassung der Stromstärke- bzw. Spannungswerte in mehreren Energieleitungen durch jeweils eine Erfassungseinheit erfolgt, die erfassten Daten jedoch in einer zentralen Auswerteeinheit ausgewertet werden. In diesem Zusammenhang kann es vorgesehen sein, dass die Auswerteeinheit dazu ausgebildet ist, die Auswertung der durch unterschiedliche Erfassungseinheiten erfassten Stromstärke- und/oder Spannungswerte parallel durchzuführen.

Wenigstens eine Auswerteeinheit und/oder wenigstens eine Steuereinheit kann derart ausgebildet sein, dass zumindest zeitweise eine Kommunikationsverbindung, insbesondere wenigstens zur Übertragung eines Auswerteergebnisses, zwischen wenigstens einer Auswerteeinheit und wenigstens einer Steuereinheit herstellbar ist.

Es ist ferner denkbar, dass die Vorrichtung zusätzlich wenigstens eines der folgenden umfasst:
- Wenigstens eine Kommunikationseinheit, insbesondere zur Übertragung wenigstens eines Fehlerdatensatzes an wenigstens einen zentralen Server und/oder wenigstens ein mobiles Gerät,
- wenigstens eine Speichereinheit zur zumindest temporären Speicherung wenigstens eines Erfassungsdatensatzes und/oder wenigstens eines Fehlerdatensatzes und/oder wenigstens einer Aktivierungsinformation,
- wenigstens eine Lokalisierungseinheit zur Erfassung wenigstens einer Standortinformation.

Wenigstens eine Kommunikationseinheit kann wenigstens eine drahtlose und/oder wenigstens eine drahtgebundene Kommunikationsschnittstelle aufweisen. Wenigstens eine drahtlose Kommunikationsschnittstelle kann als eine Bluetooth-Schnittstelle, WLAN-Schnittstelle, Troposcatter-Schnittstelle oder Mobilfunkschnittstelle ausgebildet sein.

Wenigstens eine Speichereinheit kann wenigstens einen Datenspeicher umfassen. Wenigstens ein Datenspeicher kann vorzugsweise als ein nichtflüchtiger Datenspeicher, insbesondere als SSD (Solid-State-Drive) oder Flash-Speicher oder ein magnetisches Speichermedium wie ein HDD-Speicher (Hard-Disk-Drive) ausgebildet sein.

Wenigstens eine Lokalisierungseinheit kann wenigstens einen Lokalisierungssensor umfassen. Der Lokalisierungssensor kann zum Empfang wenigstens eines Satellitensignals eines globalen Satellitennavigationssystems, vorzugsweise NAVSTAR GPS, GLONASS, Galileo oder Beidou, ausgebildet sein.

Es ist ferner denkbar, dass wenigstens zwei Einheiten aus der Gruppe Erfassungseinheit, Auswerteeinheit, Steuereinheit, Kommunikationseinheit, Speichereinheit, Lokalisierungseinheit dazu ausgebildet sind, zumindest temporär eine, vorzugsweise wechselseitige, Kommunikationsverbindung herstellen zu können. Die Kommunikationsverbindung kann zur Übertragung von Datensätzen zwischen den genannten Einheiten dienen.

Es kann im Rahmen der Erfindung vorgesehen sein, dass wenigstens zwei Einheiten aus der Gruppe Erfassungseinheit, Auswerteeinheit, Steuereinheit, Kommunikationseinheit, Speichereinheit, Lokalisierungseinheit als eine gemeinsame Einheit ausgebildet sind. Zusätzlich oder alternativ kann es vorgesehen sein, dass wenigstens zwei Einheiten aus der Gruppe Erfassungseinheit, Auswerteeinheit, Steuereinheit, Kommunikationseinheit, Speichereinheit, Lokalisierungseinheit auf einer gemeinsamen Leiterplatte angeordnet sind.

Eine zumindest temporäre Kommunikation zwischen wenigstens zwei Einheiten aus der Gruppe Erfassungseinheit, Auswerteeinheit, Steuereinheit, Kommunikationseinheit, Speichereinheit, Lokalisierungseinheit kann zumindest teilweise drahtlos und/oder zumindest teilweise drahtgebunden erfolgen. Insbesondere ist es denkbar, dass die Kommunikation zwischen wenigstens zwei Einheiten aus der Gruppe Erfassungseinheit, Auswerteeinheit, Steuereinheit, Kommunikationseinheit, Speichereinheit, Lokalisierungseinheit über Leiterbahnen einer gemeinsamen Leiterplatte erfolgt.

Es kann im Rahmen der Erfindung ferner vorgesehen sein, dass wenigstens eine Vorrichtung wenigstens zwei Erfassungseinheiten umfasst, wobei jede der Erfassungseinheiten zur Erfassung von Stromstärkewerten und/oder Spannungswerten durch eine zeitdiskrete Erfassung der elektrischen Stromstärke und/oder elektrischen Spannung in jeweils einer Energieleitung ausgebildet ist.

Auch ist es denkbar, dass die Vorrichtung nach einem erfindungsgemäßen Verfahren betreibbar ist. Insbesondere kann es vorgesehen sein, dass die Vorrichtung nach einem erfindungsgemäßen Verfahren, insbesondere nach einem Verfahren gemäß einem der Ansprüche 1 bis 10, betreibbar ist.

Es kann im Rahmen der Erfindung vorgesehen sein, dass wenigstens eine Erfassungseinheit, wenigstens eine Auswerteeinheit, wenigstens eine Steuereinheit, wenigstens eine Lokalisierungseinheit, wenigstens eine Kommunikationseinheit und/oder wenigstens eine Speichereinheit Mittel zur Datenverarbeitung, insbesondere wenigstens einen Prozessor und/oder wenigstens einen Arbeitsspeicher umfasst. Insbesondere kann es vorgesehen sein, dass wenigstens eine der genannten Einheiten dazu ausgebildet ist, Code-Anweisungen auszuführen. Bei den Code-Anweisungen kann es sich um Anweisungen gemäß eines erfindungsgemäßen Computerprogrammprodukts handeln.

Die obenstehende Aufgabe wird ferner gelöst durch eine erfindungsgemäße Transformatorenstation umfassend wenigstens einen Transformator zur Umwandlung von Mittelspannung in Niederspannung sowie wenigstens eine erfindungsgemäße Vorrichtung, insbesondere eine Vorrichtung nach einem der Ansprüche 11 bis 12, wobei die Vorrichtung derart in der Transformatorenstation angeordnet ist, dass wenigstens eine zumindest abschnittsweise in der Transformatorenstation angeordnete Energieleitung eines Niederspannungsnetzes durch die Vorrichtung überwachbar ist. Wenigstens ein Transformator kann eine Schnittstelle bzw. einen Übergang zwischen einem Mittelspannungsnetz und einem Niederspannungsnetz bilden. Es ergeben sich die gleichen Vorteile wie sie bereits in Bezug auf ein erfindungsgemäßes Verfahren und/oder eine erfindungsgemäße Vorrichtung beschrieben wurden.

Die obenstehende Aufgabe wird ferner gelöst durch ein erfindungsgemäßes System zur Überwachung wenigstens einer Energieleitung in einem Niederspannungsnetz, umfassend wenigstens eine erfindungsgemäße Vorrichtung, insbesondere eine Vorrichtung nach einem der Ansprüche 11 bis 12, und/oder wenigstens eine erfindungsgemäße Transformatorenstation, insbesondere eine Transformatorenstation nach Anspruch 13, sowie wenigstens einen zentralen Server und/oder wenigstens ein mobiles Gerät. Es kann im Rahmen der Erfindung vorgesehen sein, dass das System, insbesondere wenigstens eine Vorrichtung des Systems, nach einem erfindungsgemäßen Verfahren, insbesondere einem Verfahren gemäß einem der Ansprüche 1 bis 10, betreibbar ist. Durch ein erfindungsgemäßes System zur Überwachung wenigstens einer Energieleitung ergeben sich die gleichen Vorteile wie sie bereits in Bezug auf ein erfindungsgemäßes Verfahren, eine erfindungsgemäße Vorrichtung und eine erfindungsgemäße Transformatorenstation beschrieben wurden.

Wenigstens ein mobiles Gerät kann im Rahmen der vorliegenden Erfindung als ein Mobiltelefon, insbesondere als ein Smartphone, oder als ein Tablet oder als ein Laptop ausgebildet sein. Auch kann wenigstens ein mobiles Gerät als eine Smartwatch ausgebildet sein.

Es kann vorgesehen sein, dass wenigstens ein zentraler Server wenigstens einen Rechner umfasst. Insbesondere kann es vorgesehen sein, dass ein zentraler Server mehrere Rechner umfasst, welche über ein Netzwerk miteinander verbunden sind. Es kann im Rahmen der Erfindung vorgesehen sein, dass durch den zentralen Server bzw. durch wenigstens einen zentralen Server ein Cloud-System ausgebildet wird. Wenigstens ein zentraler Server kann dazu ausgebildet sein, zumindest temporär mit einer erfindungsgemäßen Vorrichtung und/oder wenigstens einem mobilen Gerät, insbesondere über ein Netzwerk (bspw. das Internet) und/oder ein Mobilfunknetz, zu kommunizieren.

Die obenstehende Aufgabe wird ferner gelöst durch ein erfindungsgemäßes Computerprogrammprodukt, umfassend Befehle, die bewirken, dass eine erfindungsgemäße Vorrichtung, insbesondere eine Vorrichtung gemäß einem der Ansprüche 11 bis 12, ein erfindungsgemäßes Verfahren, insbesondere ein Verfahren gemäß einem der Ansprüche 1 bis 10, ausführt.

Die obenstehende Aufgabe wird ferner gelöst durch ein erfindungsgemäßes Computerlesbares Speichermedium, auf dem ein erfindungsgemäßes Computerprogrammprodukt, insbesondere ein Computerprogrammprodukt gemäß Anspruch 15 gespeichert ist.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei zeigt
- Fig. 1: eine schematische Darstellung eines Energieversorgungsnetzes,
- Fig. 2: eine schematische Darstellung einer erfindungsgemäßen Vorrichtung,
- Fig. 3: eine schematische Darstellung einer erfindungsgemäßen Transformatorenstation,
- Fig. 4: eine schematische Darstellung eines erfindungsgemäßen Systems,
- Fig. 5: eine schematische Darstellung eines erfindungsgemäßen Verfahrens und
- Fig 6: eine schematische Darstellung eines exemplarischen Spannungs- bzw. Stromverlaufs

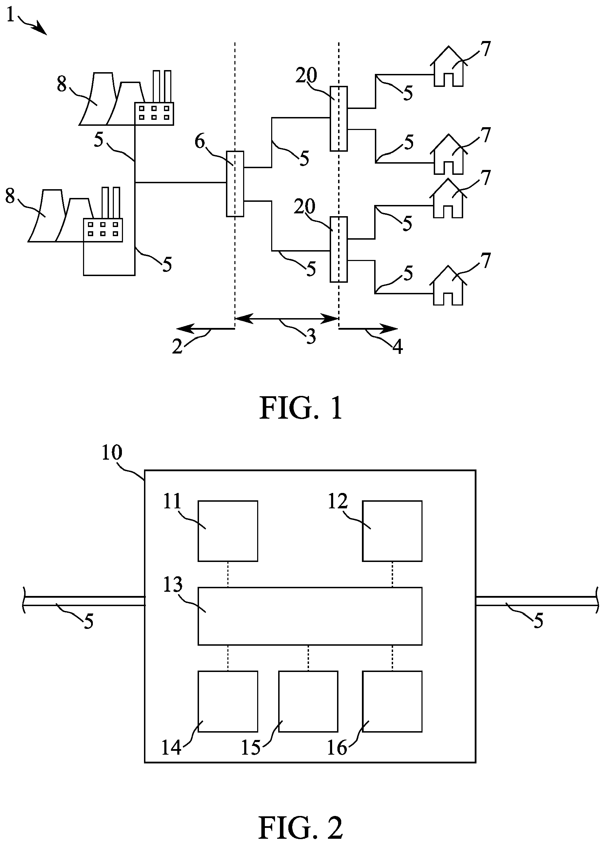

Fig. 1 zeigt eine schematische Darstellung eines Energieversorgungsnetzes 1 zur Energieversorgung von Haushalten und Industriebetrieben (Endkunden 7). Das Energieversorgungsnetz 1 umfasst mehrere Spannungsebenen. Gezeigt sind ein Hochspannungsnetz 2, ein Mittelspannungsnetz 3 sowie ein Niederspannungsnetz 4. Durch das Hochspannungsnetz 2 erfolgt eine überregionale Verteilung des elektrischen Stroms ausgehend von den Energieerzeugern 8. Vorliegend sind die Energieerzeuger 8 als Kraftwerke dargestellt. Mögliche Kraftwerksformen sind bspw. Kohle-, Gas- oder Kernkraftwerke. Die Energieerzeuger 8 können jedoch auch Energieerzeuger 8 sein, welche regenerative Energien wie Solarenergie, Windenergie oder Wasserkraft nutzen.

Eine an das Hochspannungsnetz 2 anschließende regionale Unterverteilung erfolgt in dem Mittelspannungsnetz 3, wobei die Umwandlung der elektrischen Spannung von Hoch- auf Mittelspannung durch ein Umspannwerk 6 erfolgt. Die Belieferung der Endkunden 7 erfolgt schließlich über das an das Mittelspannungsnetz 3 anschließende Niederspannungsnetz 4. Die Umwandlung von Mittelspannung auf Niederspannung erfolgt durch Transformatorenstationen 20. Das Hochspannungsnetz, das Mittelspannungsnetz und das Niederspannungsnetz umfassen jeweils mehrere Energieleitungen 5.

Fig. 2 zeigt eine schematische Darstellung einer erfindungsgemäßen Vorrichtung 10 zur Überwachung einer Energieleitung 5. Die gezeigte Energieleitung 5 ist Teil eines Niederspannungsnetzes 4. Die Vorrichtung 10 umfasst eine Erfassungseinheit 11 zur zeitdiskreten Erfassung der elektrischen Stromstärke und elektrischen Spannung in der Energieleitung 5. Ferner umfasst die Vorrichtung 10 eine Auswerteeinheit 12 zur Auswertung wenigstens eines durch die Erfassungseinheit 11 erfassten Stromstärke- und/oder Spannungswerts. Auch ist eine Steuereinheit 13 durch die Vorrichtung 10 umfasst, wobei die Steuereinheit 13 wenigstens zur Aktivierung eines Alarmprotokolls ausgebildet ist.

Ferner umfasst die Vorrichtung 10 gemäß Fig. 2 eine Kommunikationseinheit 14 zur Übertragung wenigstens eines Fehlerdatensatzes an wenigstens einen zentralen Server 18 und/oder an wenigstens ein mobiles Gerät 17. Zusätzlich umfasst ist eine Speichereinheit 15 zur zumindest temporären Speicherung wenigstens eines Erfassungsdatensatzes und/oder wenigstens eines Fehlerdatensatzes und/oder wenigstens eines Aktivierungsdatensatzes. Ferner ist eine Lokalisierungseinheit 16 durch die Vorrichtung 10 umfasst, wobei die Lokalisierungseinheit 16 zur Erfassung wenigstens einer Standortinformation ausgebildet ist.

In Fig. 2 ist durch die gestrichelten Linien dargestellt, dass zwischen der Steuereinheit 13 und den anderen durch die Vorrichtung 10 umfassten Einheiten 11, 12, 14, 15, 16 zumindest temporär eine, vorzugsweise wechselseitige, Kommunikationsverbindung herstellbar ist. Die Kommunikationsverbindung ist dazu ausgebildet Datensätze, insbesondere Fehlerdatensätze und/oder Erfassungsdatensätze und/oder Aktivierungsdatensätze, und/oder Informationen, insbesondere Lokalisierungsinformationen, Leitungsinformationen und/oder Aktivierungsinformationen, und/oder Betriebsanweisungen zu versenden, bereitzustellen und/oder zu empfangen.

Vorliegend dient die Steuereinheit 13 gemäß Fig. 2 als zentrale Schnittstelle zur vorrichtungsinternen Kommunikation zwischen den umfassten Einheiten 11, 12, 13, 14, 15, 16. Es kann jedoch ebenfalls im Rahmen der Erfindung vorgesehen sein, dass einzelne Einheiten (bspw. die Erfassungseinheit 11 und die Auswerteeinheit 12) unmittelbar miteinander kommunizieren.

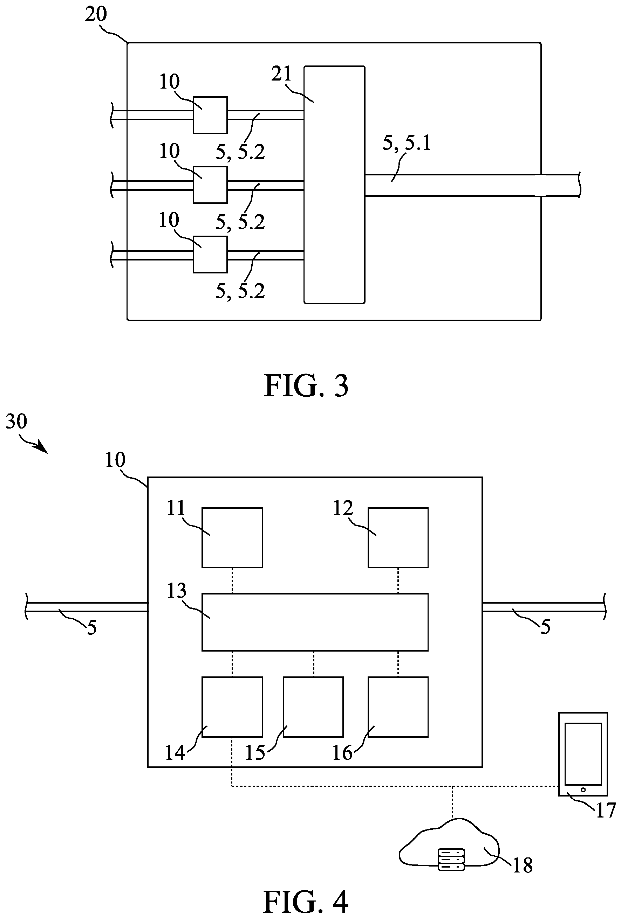

Fig. 3 zeigt eine schematische Darstellung einer erfindungsgemäßen Transformatorenstation 20. Die Transformatorenstation 20 umfasst wenigstens einen Transformator 21 zur Umwandlung von Mittelspannung in Niederspannung. Die Transformatorenstation 20 bildet somit eine Schnittstelle bzw. einen Übergang zwischen einem Mittelspannungsnetz 3 und einem Niederspannungsnetz 4.

In der Transformatorenstation 20 in wenigstens abschnittsweise zumindest eine erste Energieleitung 5.1 angeordnet bzw. mit dem Transformator 21 verbunden, wobei die erste Energieleitung 5.1 eine Energieleitung 5 eines Mittelspannungsnetzes 3 ist. Ferner ist in der Transformatorenstation 20 zumindest abschnittsweise wenigstens eine zweite Energieleitung 5.2 angeordnet bzw. mit dem Transformator 21 verbunden, wobei die zweite Energieleitung 5.2 eine Energieleitung 5 eines Niederspannungsnetzes 4 ist. Die Transformatorenstation 20 umfasst ferner wenigstens eine erfindungsgemäße Vorrichtung 10, wobei die Vorrichtung 10 derart angeordnet ist, dass wenigstens eine zumindest abschnittsweise in der Transformatorenstation 20 angeordnete Energieleitung 5 eines Niederspannungsnetzes 4 durch die Vorrichtung 10 überwachbar ist. Vorliegend sind drei zweite Energieleitungen 5.2 eines Niederspannungsnetzes 4 dargestellt, wobei jeder der zweiten Energieleitungen 5.2 des Niederspannungsnetzes 4 jeweils eine Vorrichtung 10 zur Überwachung der jeweiligen Energieleitung 5 zugeordnet ist.

Fig. 4 zeigt ein erfindungsgemäßes System 30 zur Überwachung wenigstens einer Energieleitung 5 in einem Niederspannungsnetz 4. Die Fig. 4 zeigt die Vorrichtung 10 der Fig. 2, wobei durch das System 30 neben der Vorrichtung 10 wenigstens ein zentraler Server 18 und/oder wenigstens ein mobiles Gerät 17 umfasst ist. Wie durch die gestrichelten Linien dargestellt, kann es vorgesehen sein, dass die Vorrichtung 10, insbesondere die Kommunikationseinheit 14 der Vorrichtung 10, dazu ausgebildet ist, zumindest temporär eine, insbesondere wechselseitige, Kommunikationsverbindung zu dem mobilen Gerät 17 und/oder dem zentralen Server 18 herstellen zu können. Über eine solche Kommunikationsverbindung können Datensätze und/oder Informationen und/oder Betriebsanweisungen zwischen der Vorrichtung 10 und dem zentralen Server 18 und/oder dem mobilen Gerät 17 ausgetauscht bzw. übertragen werden. Die in Fig. 4 dargestellte Vorrichtung 10 kann in einer Transformatorenstation 20 (bspw. gemäß Fig. 3) angeordnet sein.

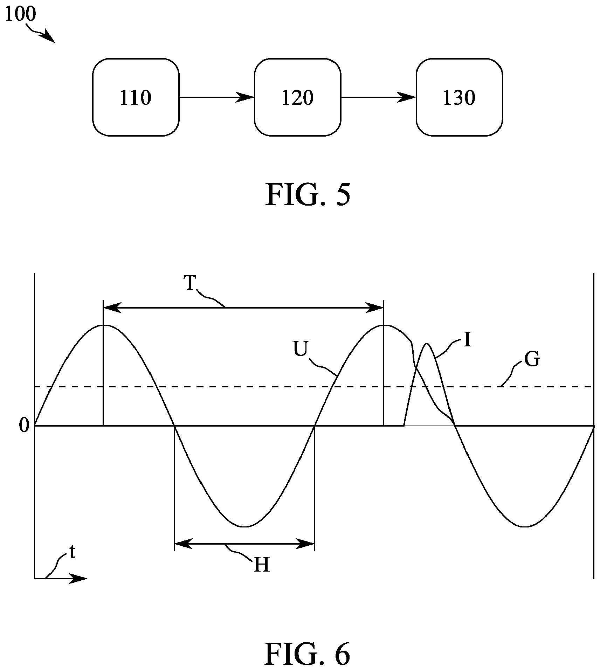

Fig. 5 zeigt ferner eine schematische Darstellung eines erfindungsgemäßen Verfahrens 100 zur Überwachung wenigstens einer Energieleitung 5 eines Niederspannungsnetzes 4, wobei an der Energieleitung 5 zumindest temporär eine, vorzugsweise sinusförmige, elektrische Wechselspannung mit einer ersten Frequenz anliegt, das Verfahren 100 wenigstens umfassend:
- Erfassen 110 von Stromstärkewerten I durch eine zeitdiskrete Erfassung der elektrischen Stromstärke in der Energieleitung 5, wobei die Erfassung der Stromstärkewerte I mit einer zweiten Frequenz erfolgt, wobei die zweite Frequenz zur Erfassung der Stromstärkewerte I höher ist als die erste Frequenz der Wechselspannung,
- Auswerten 120 wenigstens eines Stromstärkewerts I, das Auswerten 120 umfassend einen Vergleich wenigstens eines Stromstärkewerts I mit einem Stromstärkegrenzwert G,
- Aktivieren 130 eines Alarmprotokolls, sofern der Stromstärkegrenzwert G durch wenigstens einen der erfassten Stromstärkewerte I überschritten wurde.

Fig. 6 zeigt ferner eine schematische Darstellung eines exemplarischen Stromstärke- und Spannungsverlaufs in einer Energieleitung 5 eines Niederspannungsnetzes 4 beim Auftreten eines Fehlers. Aufgetragen sind die Stromstärkewerte I sowie die Spannungswerte U über der Zeit t. Der Übersicht halber sind die Stromstärkewerte I und die Spannungswerte U als kontinuierliche Linie aufgetragen. Es ergibt sich aus den vorhergehenden Ausführungen, dass sich die hier gezeigten kontinuierlichen Linien aus zeitlich diskreten Messwerten für Stromstärke (Stromstärkewerte) und Spannung (Spannungswerte) ergeben.

Aus Fig. 6 wird ersichtlich, dass die an der Energieleitung 5 anliegende Spannung eine sinusförmige Wechselspannung mit einem zeitlich periodischen Verlauf ist. Die Frequenz der Wechselspannung ergibt sich dabei als Kehrwert der in Fig. 6 dargestellten Periodendauer T der Wechselspannung. Eine Halbschwingung H der Wechselspannung ist ebenfalls gekennzeichnet.

Entsprechend der Fig. 6 erfolgt im Rahmen eines erfindungsgemäßen Verfahrens 100 eine Erfassung von Stromstärkewerten I durch eine zeitdiskrete Erfassung der elektrischen Stromstärke in einer Energieleitung 5 eines Niederspannungsnetzes. Ferner erfolgt die Auswertung wenigstens eines Stromstärkewerts I, wobei die Auswertung einen Vergleich des Stromstärkewerts I mit einem Stromstärkegrenzwert G umfasst. Sofern der Stromstärkegrenzwert G durch wenigstens einen erfassten Stromstärkewert I überschritten wurde, wird ein Alarmprotokoll aktiviert.

Es wird aus Fig. 6 ferner ersichtlich, dass der Fehler in der Energieleitung 5 in einer Halbwelle der Spannung durchzündet. Dies hat einen entsprechenden Anstieg der Stromstärke zur Folge. Beim nächsten Nulldurchgang der Wechselspannung ist die Stromstärke jedoch bereits wieder auf ihren Ausgangswert zurückgekehrt. Es wurde im Rahmen der Erfindung festgestellt, dass sich schwerwiegende Kabelfehler in einer Energieleitung 5 durch ein solches Verhalten ankündigen können. Da der Fehlerstrom nur sehr kurzzeitig auftritt, ist es vorgesehen, dass die Erfassungsfrequenz zur Erfassung der Stromstärkewerte I größer ist als die Frequenz der Wechselspannung. Hierdurch können Fehlerereignisse, wie bspw. in Fig. 6 dargestellt, zuverlässig erkannt werden. Entsprechend kann durch die vorliegende Erfindung der zuverlässige und stabile Betrieb eines Niederspannungsnetzes 4 auf einfache Weise sichergestellt werden.

### Bezupszeichenliste

- 1: Energieversorgungsnetz
- 2: Hochspannungsnetz
- 3: Mittelspannungsnetz
- 4: Niederspannungsnetz
- 5: Energieleitung
- 5.1: Erste Energieleitung
- 5.2: Zweite Energieleitung
- 6: Umspannwerk
- 7: Endkunde
- 8: Energieerzeuger

- 10: Vorrichtung
- 11: Erfassungseinheit
- 12: Auswerteeinheit
- 13: Steuereinheit
- 14: Kommunikationseinheit
- 15: Speichereinheit
- 16: Lokalisierungseinheit
- 17: Mobiles Gerät
- 18: Zentraler Server

- 20: Transformatorenstation
- 21: Transformator

- 30: System

- 100: Verfahren
- 110: Erfassen
- 120: Auswerten
- 130: Aktivieren

- G: Stromstärkegrenzwert
- H: Halbschwingung
- I: Stromstärkewert
- T: Periodendauer
- t: Zeit
- U: Spannungswert

## Patentansprüche

1. Verfahren (100) zur Überwachung wenigstens einer Energieleitung (5) in einem Niederspannungsnetz (4), wobei an der Energieleitung (5), zumindest temporär, eine, vorzugsweise sinusförmige, elektrische Wechselspannung mit einer ersten Frequenz anliegt, das Verfahren (100) wenigstens umfassend:
- Erfassen (110) von Stromstärkewerten (I) durch eine zeitdiskrete Erfassung der elektrischen Stromstärke in der Energieleitung (5), wobei die Erfassung der Stromstärkewerte (I) mit einer zweiten Frequenz erfolgt, wobei die zweite Frequenz zur Erfassung der Stromstärkewerte (I) höher ist als die erste Frequenz der Wechselspannung,
- Auswerten (120) wenigstens eines Stromstärkewerts (I), das Auswerten (120) umfassend einen Vergleich wenigstens eines Stromstärkewerts (I) mit einem Stromstärkegrenzwert (G),
- Aktivieren (130) eines Alarmprotokolls, sofern der Stromstärkegrenzwert (G) durch wenigstens einen der erfassten Stromstärkewerte (I) überschritten wurde.

2. Verfahren (100) nach Anspruch 1,
**dadurch gekennzeichnet,**
**dass** in jeder Halbschwingung (H) der Wechselspannung wenigstens 10 oder wenigstens 100 Stromstärkewerte (I), insbesondere wenigstens 1000 Stromstärkewerte (I), vorzugsweise wenigstens 100000 Stromstärkewerte (I), erfasst werden, und/oder dass die zweite Frequenz zur Erfassung der Stromstärkewerte (I) wenigstens 800 Hz, insbesondere wenigstens 1 kHz, vorzugsweise wenigstes 1 MHz, besonders bevorzugt wenigstens 2 MHz oder wenigstens 5 MHz beträgt.

3. Verfahren (100) nach einem der vorhergehenden Ansprüche,
**dadurch gekennzeichnet,**
**dass** der Stromstärkegrenzwert (G) ein Vielfaches, insbesondere das Dreifache bis Vierfache, des Nennstroms einer der Energieleitung (5) zugeordneten Sicherung beträgt, wobei vorzugsweise der Nennstrom der der Energieleitung (5) zugeordneten Sicherung 160 A, 200 A oder 250 A beträgt.

4. Verfahren (100) nach einem der vorhergehenden Ansprüche,
**dadurch gekennzeichnet,**
**dass** zusätzlich wenigstens eines der folgenden umfasst ist:
- Erfassen von Spannungswerten (U) durch eine zeitdiskrete Erfassung der elektrischen Spannung in der Energieleitung (5), wobei vorzugsweise die Erfassung der Spannungswerte (U) mit der gleichen Frequenz erfolgt wie die Erfassung der Stromstärkewerte (I) und/oder die Erfassung eines Spannungswerts (U) jeweils gleichzeitig mit der mit der Erfassung eines Stromstärkewerts (I) erfolgt,
- Auswerten wenigstens eines Spannungswerts (U).

5. Verfahren (100) nach einem der vorhergehenden Ansprüche,
**dadurch gekennzeichnet,**
**dass** zusätzlich wenigstens eines der folgenden umfasst ist:
- Erstellen wenigstens eines Erfassungsdatensatzes, umfassend wenigstens einen Stromstärkewert (I) sowie wenigstens einen Zeitstempel, wobei jedem Stromstärkewert (I) in dem Erfassungsdatensatz ein Zeitstempel zugeordnet ist,
- Speichern wenigstens eines Erfassungsdatensatzes, wobei insbesondere jedem Erfassungsdatensatz ein übergeordneter Zeitstempel zugeordnet ist,
- Berechnen wenigstens einer Zeitdifferenz zwischen wenigstens einem in einem Erfassungsdatensatz enthaltenen Zeitstempel und einem Referenzzeitstempel und Löschen des dem Zeitstempel zugeordneten Stromstärkewertes (I) und/oder Spannungswertes (U), sofern die Zeitdifferenz einen Zeitgrenzwert überschreitet und/oder
Berechnen, wenigstens einer Zeitdifferenz zwischen wenigstens einem übergeordneten Zeitstempel eines Erfassungsdatensatzes und einem Referenzzeitstempel und Löschen des dem übergeordneten Zeitstempel zugeordneten Erfassungsdatensatzes, sofern die Zeitdifferenz einen Zeitgrenzwert überschreitet.

6. Verfahren (100) nach Anspruch 5,
**dadurch gekennzeichnet,**
**dass** wenigstens ein Erfassungsdatensatz wenigstens eine der nachfolgenden Informationen umfasst:
- Eine Lokalisierungsinformation,
- Eine Leitungsinformation.

7. Verfahren (100) nach einem der vorhergehenden Ansprüche,
**dadurch gekennzeichnet,**
**dass** das Alarmprotokoll zusätzlich wenigstens eines der nachfolgenden umfasst:
- Erstellen wenigstens eines Fehlerdatensatzes, umfassend wenigstens einen Stromstärkewert (I) sowie wenigstens einen Zeitstempel, wobei jedem Stromstärkewert (I) in dem Fehlerdatensatz ein Zeitstempel zugeordnet ist,
- Übertragen wenigstens eines Fehlerdatensatzes an wenigstens einen zentralen Server (18) und/oder an wenigstens ein mobiles Gerät (17),
- Empfangen wenigstens einer Betriebsanweisung, insbesondere von einem zentralen Server (18) und/oder einem mobilen Gerät (17),
- Durchführen einer Fehlerortung an der Energieleitung (5), insbesondere durch Impulsreflexion, insbesondere dass wenigstens ein Fehlerdatensatz wenigstens eine der nachfolgenden Informationen umfasst:
- Eine Lokalisierungsinformation,
- Eine Leitungsinformation, und/oder dass der Fehlerdatensatz wenigstens zwei, vorzugsweise wenigstens drei, Stromstärkewerte (I) in einem, insbesondere zusammenhängenden, Erfassungszeitraum umfasst.

8. Verfahren (100) nach Anspruch 7,
**dadurch gekennzeichnet,**
**dass** ein Anfangszeitpunkt des Erfassungszeitraums durch eines der folgenden Ereignisse festgelegt ist:
- Überschreiten des Stromstärkegrenzwerts (G) durch wenigstens einen Stromstärkewert (I),
- Ein Anstieg der Stromstärke über wenigstens drei zeitlich aufeinanderfolgend erfasste Stromstärkewerte (I) hinweg, wobei insbesondere die Steigung der Stromstärke zwischen je zwei Stromstärkewerten (I) jeweils größer ist als ein vordefinierter Steigungsgrenzwert.

9. Verfahren (100) nach einem der Ansprüche 7 oder 8,
**dadurch gekennzeichnet,**
**dass** ein Endzeitpunkt des Erfassungszeitraums durch wenigstens eines der folgenden Ereignisse festgelegt ist:
- Unterschreiten des Stromstärkegrenzwerts (G) durch wenigstens einen Stromstärkewert (I),
- Ablauf einer Zeitspanne ab dem Anfangszeitpunkt des Erfassungszeitraums, wobei die Zeitspanne wenigstens ein Viertel, vorzugsweise wenigstens die Hälfte, der Periodendauer (T) der an der Energieleitung (5) anliegenden Wechselspannung beträgt.

10. Verfahren (100) nach einem der vorhergehenden Ansprüche,
**dadurch gekennzeichnet,**
**dass** das Alarmprotokoll zusätzlich umfasst:
- Auswerten wenigstens eines Spannungswertes (U) in einem Auswertezeitraum vor dem Zeitstempel des ältesten Stromstärkewerts (I) in einem Fehlerdatensatz, durch den der Stromstärkegrenzwert (G) überschritten wurde und Deaktivieren des Alarmprotokolls, sofern wenigstens ein Spannungswert (U) in dem Auswertezeitraum, insbesondere wenigstens zwei aufeinanderfolgend erfasste Spannungswerte (U) in dem Auswertezeitraum, den Wert null aufweist.

11. Vorrichtung (10), die insbesondere nach einem Verfahren (100) gemäß einem der Ansprüche 1 bis 10 betreibbar ist, zur Überwachung wenigstens einer Energieleitung (5) in einem Niederspannungsnetz (4), umfassend:
- Wenigstens eine Erfassungseinheit (11) zur Erfassung von Stromstärkewerten (I) durch eine zeitdiskrete Erfassung der elektrischen Stromstärke in wenigstens einer Energieleitung (5),
- Wenigstens eine Auswerteeinheit (12) zur Auswertung wenigstens eines Stromstärkewerts (I),
- Wenigstens eine Steuereinheit (13) zur Aktivierung eines Alarmprotokolls.

12. Vorrichtung (10) nach Anspruch 11,
**dadurch gekennzeichnet,**
**dass** die Vorrichtung (10) zusätzlich wenigstens eines der folgenden umfasst:
- Wenigstens eine Kommunikationseinheit (14), insbesondere zur Übertragung wenigstens eines Fehlerdatensatzes an wenigstens einen zentralen Server (18) und/oder wenigstens ein mobiles Gerät (17),
- Wenigstens eine Speichereinheit (15) zur zumindest temporären Speicherung wenigstens eines Erfassungsdatensatzes und/oder wenigstens eines Fehlerdatensatzes und/oder wenigstens einer Aktivierungsinformation,
- Wenigstens eine Lokalisierungseinheit (16) zur Erfassung wenigstens einer Standortinformation.

13. Transformatorenstation (20) umfassend wenigstens einen Transformator (21) zur Umwandlung von Mittelspannung in Niederspannung sowie wenigstens eine Vorrichtung (10) nach einem der Ansprüche 11 bis 12, wobei die Vorrichtung (10) derart in der Transformatorenstation (20) angeordnet ist, dass wenigstens eine zumindest abschnittsweise in der Transformatorenstation (20) angeordnete Energieleitung (5) eines Niederspannungsnetzes (4) durch die Vorrichtung (10) überwachbar ist.

14. System (30) zur Überwachung wenigstens einer Energieleitung (5) in einem Niederspannungsnetz (4), umfassend wenigstens eine Vorrichtung (10) nach einem der Ansprüche 11 bis 12 sowie wenigstens einen zentralen Server (18) und/oder wenigstens ein mobiles Gerät (17).

15. Computerprogrammprodukt, umfassend Befehle, die bewirken, dass eine Vorrichtung (10) gemäß einem der Ansprüche 11 bis 12 ein Verfahren (100) gemäß einem der Ansprüche 8 bis 10 ausführt.

16. Computerlesbares Speichermedium, auf dem ein Computerprogrammprodukt nach Anspruch 15 gespeichert ist.
